# EUROPEAN PATENT APPLICATION

(11) **EP 4 841 407 A1**
(43) Date of publication of application: **18.11.2026**
(21) Application number: 26169817.9
(22) Date of filing: 31.03.2026
(51) Int. Cl.: G06F 3/041, G06F 3/044, H10K 59/131

(54) **DISPLAY DEVICE AND ELECTRONIC DEVICE**

(30) Priority: 14.05.2025 KR 20250062707
(71) Applicant: Samsung Display Co., Ltd., Yongin-si, Gyeonggi-do 17113 (KR)
(72) Inventor: Jung, Min Sun, Yongin-si, Gyeonggi-do (KR)
(74) Representative: Gulde & Partner

(57) **Abstract**

A display device (1) includes a display module (11) including a display panel (100) including pixels (PX) on a substrate (110), sensor electrodes (TSE) on an encapsulation layer (140) covering the pixels (PX), a display driver (200) on the substrate (110) and electrically connected to the pixels (PX), a selector (TMX) including switches (SW) electrically connected to the sensor electrodes (TSE) and on the substrate, and electrode pads (DP, TP) on the substrate (110) and including display electrode pads (DP) electrically connected to the display driver (200) and touch electrode pads (TP) electrically connected to the switches (SW), and a circuit board including connection pads (CP) connected to the electrode pads (DP, TP). The connection pads (CP) include first and second connection pads (CP1, CP2) electrically connected to different switches (SW) of the switches (SW) via different touch electrode pads (TP) and receiving selection signals (Sg) having different effective voltages. The circuit board includes a voltage pad (VP) between the first connection pad (CP1) and the second connection pad (CP2) and receiving a constant voltage having an effective voltage greater than the effective voltages of the selection signals (Sg).

## Description

### BACKGROUND

Some example embodiments of the present disclosure relate to a display device and an electronic device configured to display an image.

With the advances in information society, there is an increased demand to improve the functionality of display devices and electronic devices capable of displaying images. A display device may be provided either as a standalone device, or may be included in an electronic device and used as a display screen of the electronic device.

The display device and the electronic device may provide touch input functions to improve ease of use. For example, the display device and a display module of the electronic device may include a touch sensing unit capable of sensing a touch input.

### SUMMARY

Some example embodiments of the present disclosure provide a display device and an electronic device having improved reliability.

However, example embodiments of the present disclosure are not restricted to embodiments set forth herein. The above and other aspects of the present disclosure will become more apparent to one of ordinary skill in the art to which the present disclosure pertains by referencing the detailed description of the present disclosure given below.

According to some example embodiments of the present disclosure, a display device includes a display module including (or the display device includes) a display panel having pixels on a substrate, sensor electrodes on an encapsulation layer covering the pixels, a display driver on the substrate and electrically connected to the pixels, a selector comprising a plurality of switches electrically connected to the sensor electrodes and on the substrate, and electrode pads on the substrate, the electrode pads including a plurality of display electrode pads electrically connected to the display driver and a plurality of touch electrode pads electrically connected to the plurality of switches, and a circuit board including connection pads connected to the electrode pads. The connection pads include a first connection pad and a second connection pad. The first connection pad and the second connection pad are electrically connected to different switches of the plurality of switches via different touch electrode pads of the plurality of touch electrode pads. The first connection pad and the second connection pad are configured to receive selection signals having different effective voltages, and the circuit board further includes a voltage pad between the first connection pad and the second connection pad. The voltage pad is configured to receive a constant voltage having an effective voltage greater than the effective voltages of the selection signals.

In some example embodiments, the effective voltage of the selection signal received by the second connection pad may be higher than the effective voltage of the selection signal received by the first connection pad, and the circuit board may include a plurality of voltage pads, each voltage pad of the plurality of voltage pads may be configured to receive the constant voltage and may be on opposite sides of the second connection pad.

In some example embodiments, the connection pads may include a plurality of first connection pads, each first connection pad of the plurality of first connection pads may be configured to receive a respective selection signal, the selection signals may have a same first effective voltage, and may include a plurality of second connection pads, each second connection pad of the plurality of second connection pads may be configured to receive a respective selection signal, the selection signals may have a same second effective voltage.

In some example embodiments, the circuit board may include a plurality of voltage pads, each voltage pad of the plurality of voltage pads may be configured to receive the constant voltage and may be on opposite sides of each second connection pad of the plurality of second connection pads.

In some example embodiments, the plurality of second connection pads may be sequential in an order corresponding to an arrangement of the plurality of switches of the selector.

In some example embodiments, the circuit board may include a plurality of voltage pads, each voltage pad of the plurality of voltage pads may be configured to receive the constant voltage and may be on a first side of the plurality of second connection pads and a second side of the plurality of second connection pads.

In some example embodiments, each of the connection pads and the voltage pad may include a metal core protruding from one surface of the circuit board toward the display panel, and may include a plating film covering a surface of the metal core.

In some example embodiments, the metal core may include copper, and the plating film may include nickel.

In some example embodiments, the plurality of touch electrode pads may include a channel pad that may be selectively connected to one group of sensor electrodes of the sensor electrodes by the selector.

In some example embodiments, the selector may include a first switch unit comprising a plurality of first switches individually connected to the sensor electrodes of the one group and may be configured to turn on in response to respective electrode selection signals being received by respective gate electrodes, and may include a second switch unit comprising a plurality of second switches electrically connected to different first switches of the plurality of first switches and that may be electrically connected between the first switch unit and the channel pad.

In some example embodiments, the first connection pad may be connected to a gate electrode of at least one second switch of the plurality of second switches, the at least one second switch may be electrically connected to a first number of first switches, the second connection pad may be connected to a gate electrode of at least one other second switch of the plurality of second switches, the at least one other second switch may be electrically connected to a second number of first switches, and the first number of first switches may be greater than the second number of first switches.

In some example embodiments, the first connection pad may be configured to receive a first number of gate-on pulses of a first selection signal and the second connection pad may be configured to receive a second number of gate-on pulses of a second selection signal, the first number of gate-on pulses may be greater than the second number of gate-on pulses.

In some example embodiments, each second switch of the plurality of second switches may include a P-type transistor, and an effective voltage of the second selection signal may be higher than an effective voltage of the first selection signal.

In some example embodiments, the circuit board may include a plurality of voltage pads, and the plurality of voltage pads may be on opposite sides of the second connection pad.

According to some example embodiments of the present disclosure, an electronic device may include a display device (or a display module), a processor configured to transmit an image data signal to the display module, and a power module configured to supply power to the display module. The display module may include a display panel comprising pixels on a substrate, sensor electrodes on an encapsulation layer covering the pixels, a display driver on the substrate and electrically connected to the pixels, a selector comprising a plurality of switches electrically connected to the sensor electrodes and on the substrate, and electrode pads on the substrate, the electrode pads including a plurality of display electrode pads electrically connected to the display driver and a plurality of touch electrode pads electrically connected to the plurality of switches, and a circuit board including connection pads connected to the electrode pads. The connection pads comprise a first connection pad and a second connection pad, and the first connection pad and the second connection pad are electrically connected to different switches of the plurality of switches via different touch electrode pads of the plurality of touch electrode pads, the first connection pad and the second connection pad being configured to receive selection signals having different effective voltages, and the circuit board further comprises a voltage pad between the first connection pad and the second connection pad, the voltage pad being configured to receive a constant voltage having an effective voltage greater than the effective voltages of the selection signals.

In some example embodiments, the effective voltage of the selection signal received by the second connection pad may be higher than the effective voltage of the selection signal received by the first connection pad, and the circuit board may comprise a plurality of voltage pads, each voltage pad of the plurality of voltage pads may be configured to receive the constant voltage and may be on opposite sides of the second connection pad.

In some example embodiments, the connection pads may include a plurality of first connection pads, each first connection pad of the plurality of first connection pads may be configured to receive a respective selection signal, the selection signals may have a same first effective voltage, and may include a plurality of second connection pads, each second connection pad of the plurality of second connection pads may be configured to receive a respective selection signal, the selection signals may have a same second effective voltage.

In some example embodiments, the circuit board may include a plurality of voltage pads, each voltage pad of the plurality of voltage pads may be configured to receive the constant voltage and may be on opposite sides of each second connection pad of the plurality of second connection pads.

In some example embodiments, the plurality of second connection pads may be sequential in an order corresponding to an arrangement of the plurality of switches of the selector, and the circuit board may comprise a plurality of voltage pads, each voltage pad of the plurality of voltage pads may be configured to receive the constant voltage and may be on a first side of the plurality of second connection pads and a second side of the plurality of second connection pads.

In some example embodiments, each of the connection pads and the voltage pad may include a metal core protruding from one surface of the circuit board toward the display panel, and may include a plating film covering a surface of the metal core.

The display device and the electronic device, according to some example embodiments, may include a display panel and may include a circuit board including connection pads connected to a pad portion of the display panel. The circuit board, according to some example embodiments, may include a voltage pad located around or adjacent to a connection pad. The voltage pad may be configured to receive a signal having a relatively higher effective voltage compared to signals applied to other connection pads around the connection pad, and may be configured to receive a constant voltage having an effective voltage higher than an effective voltage of input signals applied to the connection pads.

According to some example embodiments, corrosion of the connection pads located on the circuit board side may be limited, prevented, and/or suppressed. Accordingly, the quality of contact between the display panel and the circuit board may be improved, and the reliability of the display device and electronic device may be increased.

While several example embodiments have been provided in the present disclosure, it should be understood that the disclosed systems and methods might be embodied in many other specific forms without departing from the scope of the present disclosure as defined by the appended claims.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to some example embodiments.
FIG. 2 is a plan view illustrating a display module according to some example embodiments.
FIG. 3 is a cross-sectional view illustrating a display module according to some example embodiments.
FIG. 4 is a cross-sectional view illustrating a display module according to some example embodiments.
FIG. 5 is a plan view schematically showing a display unit of a display module according to some example embodiments.
FIG. 6 is a plan view schematically showing a touch sensing unit of a display module according to some example embodiments.
FIG. 7 is a plan view schematically showing a touch sensing unit of a display module according to some example embodiments.
FIG. 8 is a cross-sectional view illustrating a display area of a display panel according to some example embodiments.
FIG. 9 is a cross-sectional view illustrating a pad portion of a display module according to some example embodiments.
FIG. 10 is a diagram schematically illustrating a connection structure between sensor electrodes and touch electrode pads of a touch sensing unit according to some example embodiments.
FIG. 11 is a diagram showing a selector of a touch sensing unit according to some example embodiments.
FIG. 12 schematically shows a connection structure between a sensor electrode and a channel pad according to some example embodiments.
FIG. 13 is a diagram showing the selection order of sensor electrodes according to some example embodiments.
FIG. 14 shows a pad area of a circuit board according to some example embodiments.
FIGS. 15 and 16 are waveform diagrams showing some example embodiments of group selection signals inputted to different second switches;
FIG. 17 shows a pad area of a circuit board according to some example embodiments.
FIG. 18 shows a pad area of a circuit board according to some example embodiments.
FIG. 19 is a block diagram of an electronic device according to some example embodiments.
FIG. 20 is schematic views of electronic devices according some example embodiments.

### DETAILED DESCRIPTION OF EXAMPLE EMBODIMENTS

Some example embodiments will now be described with reference to the accompanying drawings which illustrates the example embodiments. Example embodiments may, however, be embodied in different forms and should not be construed as limited to the embodiments set forth herein. Rather, these embodiments are provided so that this disclosure will be thorough and complete, and will fully convey the scope of the disclosure as defined by the appended claims to those skilled in the art.

It will also be understood that when an element or a layer is referred to as being "on" another element or layer, it can be directly on the other element or layer, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the disclosure. Similarly, the second element could also be termed the first element.

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure as defined by the appended claims. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Features of the example embodiments of the present disclosure may be partially or entirely combined with each other and may technically variously interwork with each other, and example embodiments may be implemented independently of each other or may be implemented together in association with each other.

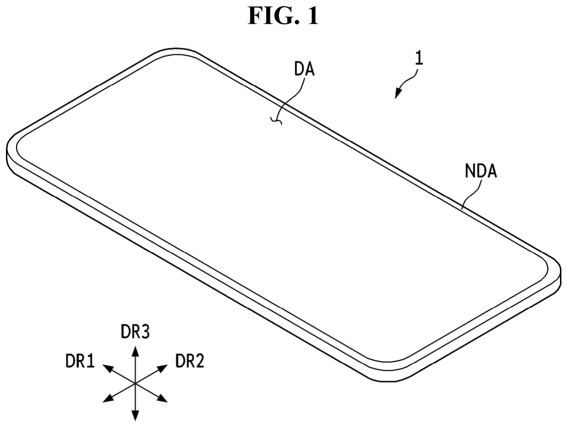

FIG. 1 illustrates a perspective view of a display device according to some example embodiments.

Referring to FIG. 1, a display device 1 may be a device configured to provide an image, such as a moving image or a still image. For example, the display device 1 may be an electronic device that includes a display module for implementing a display screen and thus may display an image. Alternatively, the display device 1 may be included in an electronic device that includes a display screen and the display device 1 may form the display screen of the electronic device. As an example, the display device 1 may refer to electronic devices that include a display screen on which an image may be displayed or include a display module for displaying an image. The electronic device including the display module or the display device 1 may include a television, a laptop computer, a monitor, a billboard, an Internet-of-Things device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder and the like, which provide a display screen.

In some example embodiments, the display device 1 may be a light emitting display device including a light emitting element such as an inorganic light emitting diode or an organic light emitting diode, but the display device 1 and the light emitting element are not limited thereto. In some example embodiments, the display device 1 may be an organic light emitting display device including an organic light emitting diode.

The display device 1 may have different shapes such as a rectangle, a square, a circle, or the like. The display device 1 may include corner portions having an angled or rounded shape. In FIG. 1, the display device 1 is illustrated as having a generally rectangular shape on a plane defined by a first direction DR1 and a second direction DR2 and having rounded corner portions. The first direction DR1 and the second direction DR2 may be the vertical direction and the horizontal direction of the display device 1, respectively. The display device 1 may have a thickness in a third direction DR3 intersecting the first direction DR1 and the second direction DR2.

The display device 1 may include a display area DA and a non-display area NDA. The display area DA is an area where an image may be displayed, and the non-display area NDA is an area where an image is not displayed. The display area DA may generally occupy the center of the display device 1. The non-display area NDA may be located around the display area DA. In some example embodiments, the non-display area NDA may be located at the edge of the display device 1 to surround the display area DA.

The display device 1 (or the display module of the electronic device) according to some example embodiments may provide a touch input function. For example, a user may control the display device 1 by touching the display area DA. According to some example embodiments, sensor electrodes for sensing a touch input may be located in the display area DA.

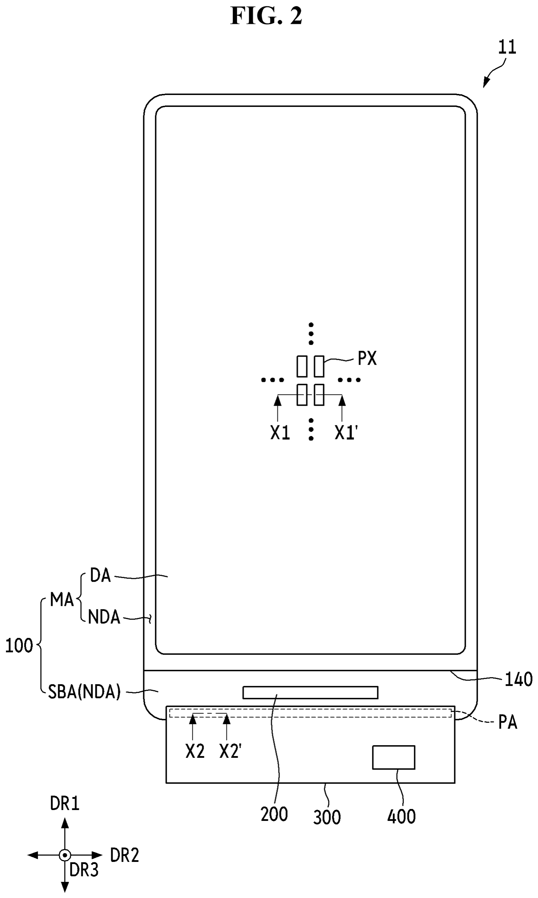

FIG. 2 is a plan view illustrating a display module according to some example embodiments. For example, FIG. 2 shows some example embodiments of a display module 11 that may be included in the display device 1 (or electronic device) of FIG. 1.

Referring to FIGS. 1 and 2, the display device 1 may include the display module 11. In some example embodiments, the display device 1 may further include a housing or case, or the like that accommodates the display module 11.

The display module 11 may include a display panel 100 for implementing a display screen, and a display driver 200 and a circuit board 300 for driving the display panel 100. In some example embodiments, the display device 1 may provide a touch input function, and the display module 11 may further include a touch driver 400.

The display panel 100 may include a main region MA. The main region MA may include the display area DA and a non-display area NDA surrounding the display area DA. In some example embodiments, the display panel 100 may further include a sub-region SBA extending from or adjacent to the main region MA. An encapsulation member (e.g., an encapsulation layer or an encapsulation substrate that encapsulates pixels PX) may be located in the main region MA, and an encapsulation member may not be located in the sub-region SBA. The sub-region SBA may be a part of the non-display area NDA. For example, other parts of the display panel 100 other than the display area DA where an image is displayed may be referred to as the non-display area NDA.

Pixels PX for displaying an image may be arranged in the display area DA. For example, the pixels PX that each emit light of a desired color (e.g., red, green, blue, or white) may be located in the display area DA, and a plurality of pixels PX that emit light of different colors may constitute one unit pixel. A unit pixel may be defined as a pixel group in a minimum unit, which may emit light of different colors including white color (e.g., standard white color).

In some example embodiments, the display panel 100 may include a touch sensing area configured to sense a touch input. For example, the display area DA may include a touch sensing area. For example, the entire display area DA, or a portion of the display area DA may be a touch sensing area. When the entire display area DA is a touch sensing area, the display area DA and the touch sensing area may be substantially the same.

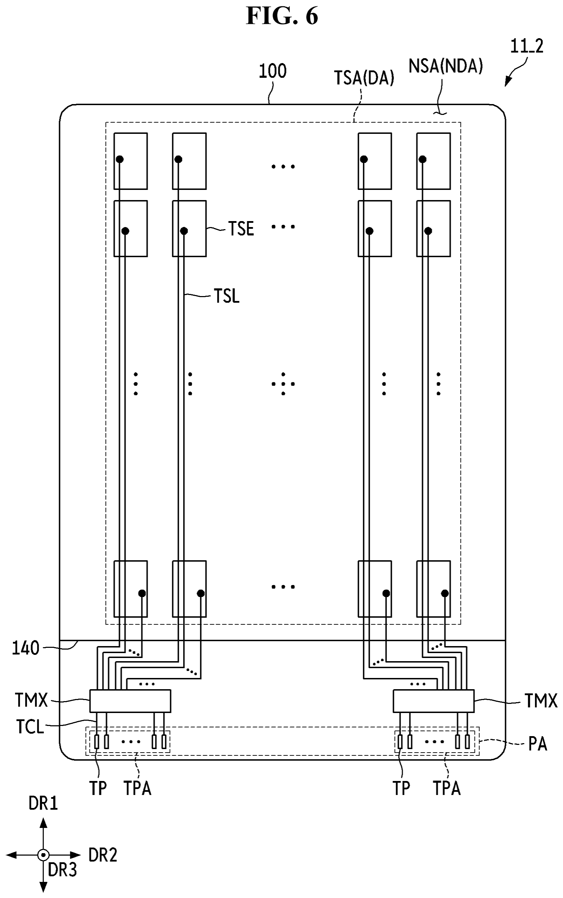

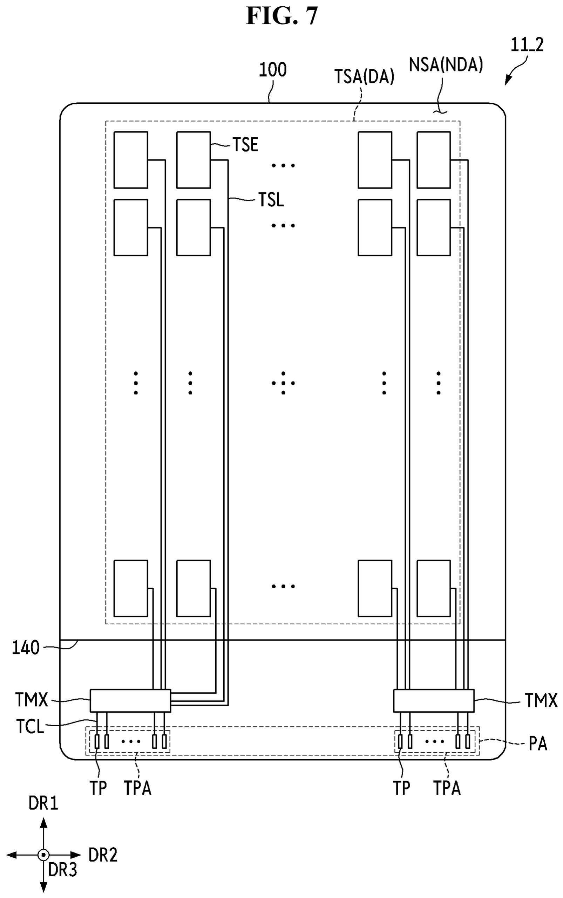

Sensor electrodes (e.g., sensor electrodes TSE of FIG. 6 or FIG. 7) for sensing a touch input may be located in the touch sensing area. For example, sensor electrodes may be located on the pixels PX of the display area DA.

Wires electrically connected to the pixels PX and the sensor electrodes may be located in the non-display area NDA. In some example embodiments, a gate driver (and other circuits) electrically connected to the pixels PX may be further located in the non-display area NDA.

The display driver 200 and a pad portion PA may be located in the sub-region SBA. The pad portion PA may include electrode pads (e.g., connection pads on the side of the display panel 100, which are bonded to connection pads of the circuit board 300) for electrically connecting the display panel 100 and the circuit board 300. In some example embodiments, when the display driver 200 is mounted on or installed in the sub-region SBA of the display panel 100, electrode pads (e.g., IC connection pads such as chip on panel (COP) pads) for electrically connecting the display panel 100 and the display driver 200 may be located also in the area in which the display driver 200 is mounted.

The display panel 100 may be substantially or entirely flat, but the display panel 100 is not limited thereto. The display panel 100 may be provided inside the display device 1 in an unfolded state, or may be provided inside the display device 1 in a bent or folded state in the sub-region SBA or the like.

The display driver 200 may output driving signals for driving the pixels PX of the display panel 100. For example, the display driver 200 may include a data driver that supplies respective data voltages to the pixels PX through data lines.

In some example embodiments, the display driver 200 may be formed as an integrated circuit (IC) and mounted on the sub-region SBA of the display panel 100. In some example embodiments, the display driver 200 may be placed on the circuit board 300 by a chip on film (COF) method, and may be electrically connected to the display panel 100 through the pad portion PA.

In some example embodiments, the display driver 200 may further include a power supply unit that generates driving voltages for driving the pixels PX, and may supply the driving voltages to power lines electrically connected to the pixels PX. In some example embodiments, the power supply unit may be provided separately from the display driver 200, and may be electrically connected to the display panel 100 through the pad portion PA. As an example, the power supply unit may be located on the circuit board 300 or on another circuit board electrically connected to the circuit board 300.

In some example embodiments, the display driver 200 may further include a timing controller that outputs driving signals for driving the gate driver and the data driver. The timing controller may output driving signals (e.g., gate control signals and data control signals) for driving the gate driver and the data driver to the gate driver and the data driver.

In some example embodiments, the timing controller may be provided separately from the display driver 200 and electrically connected to the gate driver and the data driver. As an example, the timing controller may be located on the circuit board 300 or on another circuit board electrically connected to the circuit board 300.

The circuit board 300 may be located on the pad portion PA of the display panel 100. The circuit board 300 may be electrically connected to the display panel 100 through a medium such as an anisotropic conductive film (ACF). In some example embodiments, the circuit board 300 may be a flexible printed circuit board, a printed circuit board, or a flexible film such as a chip on film.

The touch driver 400 may be mounted on the circuit board 300. In some example embodiments, the touch driver 400 may be formed as an integrated circuit (IC).

The touch driver 400 may be electrically connected to sensor electrodes of the display panel 100. In some example embodiments, the display panel 100 may further include a selector (e.g., a multiplexer) located between the sensor electrodes and the pad portion PA, and the touch driver 400 may be electrically connected to the sensor electrodes of the display panel 100 via the pad portion PA and the selector of the display panel 100.

In some example embodiments, the display panel 100 may include sensor electrodes that may form a self-capacitive touch sensor. The touch driver 400 may supply touch driving signals to the sensor electrodes and may detect a touch input by sensing the amount of change in capacitance at or adjacent the sensor electrodes. In some example embodiments, each sensor electrode may be electrically connected to the touch driver 400 through one electrode pad, and the period during which the touch driving signal is inputted and the period during which the sensing signal is outputted with respect to each sensor electrode may be temporally separated.

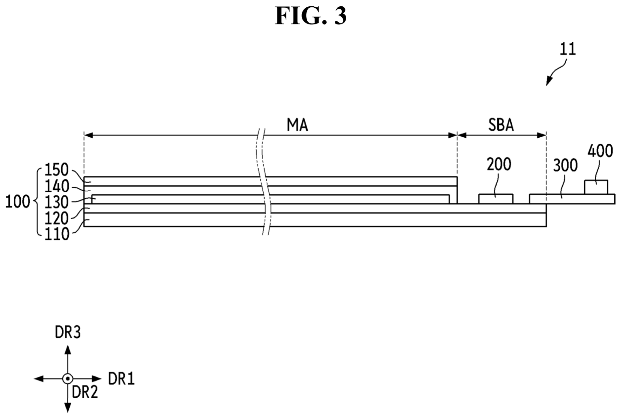

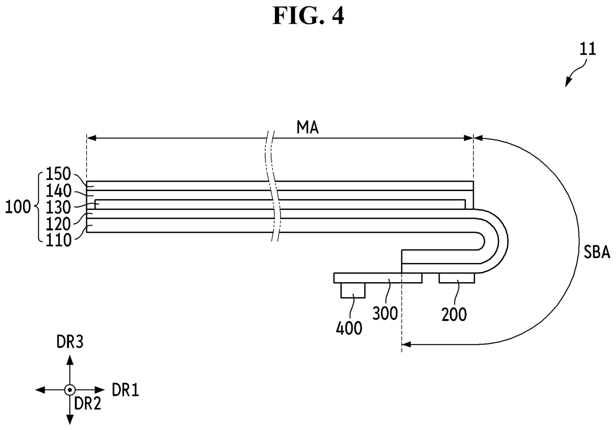

FIG. 3 is a cross-sectional view illustrating a display module according to some example embodiments. FIG. 4 is a cross-sectional view illustrating a display module according to some example embodiments. For example, FIG. 3 schematically illustrates a cross-section of the display module 11 in which the display panel 100 is unfolded, and FIG. 4 schematically illustrates a cross-section of the display module 11 in which the display panel 100 is bent in the sub-region SBA.

Referring to FIGS. 3 and 4 in addition to FIG. 2, the display panel 100 may include a substrate 110, a backplane layer 120, a light emitting element layer 130, an encapsulation layer 140 (or an encapsulation substrate), and a touch sensing layer 150. In some example embodiments, the display panel 100 may further include additional components. For example, the display panel 100 may further include an optical layer (e.g., a color filter layer, a polarizing layer, and/or an anti-reflection layer) and/or a protective layer (e.g., a protective film) located on the touch sensing layer 150.

The substrate 110 may form a base of the display panel 100 and may support the backplane layer 120, the light emitting element layer 130, and the like. The substrate 110 may be a flexible substrate which can be bent, folded, or rolled, but is not limited thereto. In some example embodiments, the substrate 110 may include a polymer resin such as polyimide (PI). In some example embodiments, the substrate 110 may include a glass material or a metal material.

The backplane layer 120 may be located or formed on the substrate 110. The backplane layer 120 may be located in the main region MA and the sub-region SBA.

The backplane layer 120 may include circuit elements of the pixels PX and wires electrically connected to the pixels PX. For example, the backplane layer 120 may include a plurality of transistors and at least one capacitor included in the pixel circuit of each of the pixels PX, and signal lines (e.g., gate lines and data lines) and power lines (e.g., a plurality of power lines including a first power line and a second power line respectively transmitting a high-potential first driving voltage and a low-potential second driving voltage) electrically connected to the pixels PX. In some example embodiments, some of the wires of the backplane layer 120 may be electrically connected to the display driver 200. For example, data lines may be electrically connected between the display driver 200 and the pixels PX.

In some example embodiments, the display panel 100 may include a gate driver located in the non-display area NDA. In some example embodiments, the backplane layer 120 may further include circuit elements included in the gate driver, and wires (e.g., gate lines connecting the pixels PX and the gate driver, and wires transmitting input signals and driving voltages to the gate driver) electrically connected to the gate driver.

In some example embodiments, the backplane layer 120 may further include sensor lines electrically connected to the sensor electrodes of the touch sensing layer 150. For example, a portion of each of the sensor lines positioned in the main region MA may be located within the touch sensing layer 150, and another portion of each of the sensor lines positioned in the sub-region SBA may be located within the backplane layer 120.

In some example embodiments, the display panel 100 may further include a selector electrically connected to the sensor electrodes of the touch sensing layer 150. For example, the backplane layer 120 may include switches electrically connected to respective sensor electrodes via respective sensor lines. In some example embodiments, the switches of the selector may be switching transistors formed simultaneously with the transistors included in the pixels PX. In some example embodiments, the selector may be mounted on the display panel 100 in the form of an integrated circuit or may be integrated within the touch driver 400.

The light emitting element layer 130 may be arranged on the backplane layer 120. The light emitting element layer 130 may be located or formed in the display area DA. The light emitting element layer 130 may include a structure (e.g., a pixel defining film or a bank) that defines or partitions emission areas of the pixels PX, and light emitting elements located in the emission areas of the pixels PX.

The encapsulation layer 140 may be located or formed on the light emitting element layer 130 and cover the pixels PX. For example, the encapsulation layer 140 may cover the top surface and the side surface of the light emitting element layer 130 to protect the light emitting element layer 130. The encapsulation layer 140 may be located at least in the display area DA. An end of the encapsulation layer 140 may be located in the non-display area NDA. In some example embodiments, the encapsulation layer 140 may include a plurality of inorganic encapsulation layers and an organic encapsulation layer interposed between the inorganic encapsulation layers. In some example embodiments, the encapsulation layer 140 may be replaced with an encapsulation substrate or the like.

The touch sensing layer 150 may be located or formed on the encapsulation layer 140. For example, the touch sensing layer 150 may be located or formed directly on the encapsulation layer 140.

The touch sensing layer 150 may include elements for generating an electrical signal in response to a user's touch input. For example, the touch sensing layer 150 may include sensor electrodes (e.g., touch electrodes corresponding to the sensor electrodes TSE in FIG. 6 or FIG. 7) located in a touch sensing area, and sensor lines electrically connected to the sensor electrodes. When the display device 1 provides the touch input function in the display area DA, the sensor electrodes may be arranged in the display area DA.

The sensor lines may be electrically connected to the sensor electrodes in the main region MA (e.g., the display area DA) where the sensor electrodes are located and may extend to the sub-region SBA. In some example embodiments, the sensor lines may be electrically connected to a selector located in the sub-region SBA. In some example embodiments, the sensor electrodes may be electrically connected to the touch driver 400 via the sensor lines, switches of the selector, and electrode pads located in the pad portion PA.

In some example embodiments, the display panel 100 may be located inside the display device 1 in an unfolded state as illustrated in FIG. 3, or may be located inside the display device 1 in a bent state as illustrated in FIG. 4. When the display panel 100 is bent in the sub-region SBA, the display driver 200, the circuit board 300, and the like may be located below the main region MA. In some example embodiments, the bezel area of the display device 1 may be reduced or minimized.

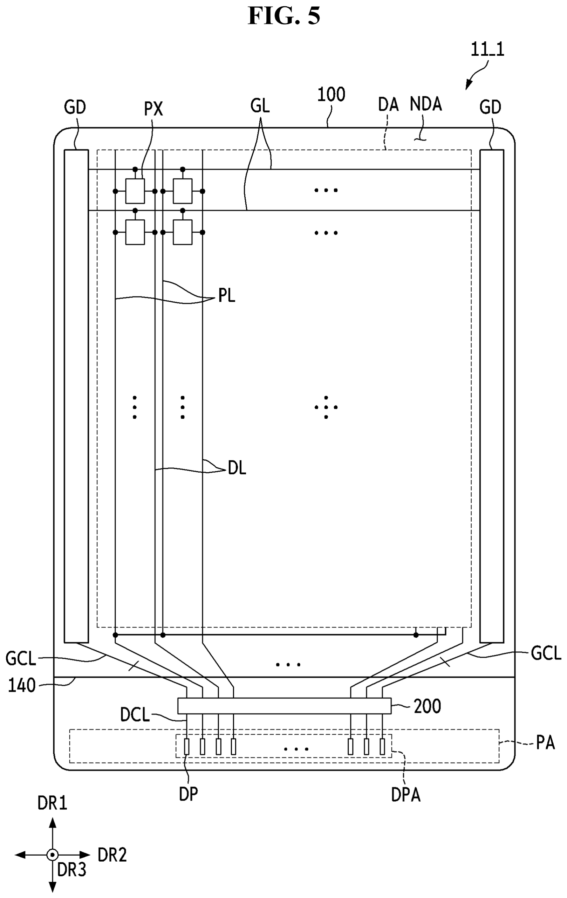

FIG. 5 is a plan view schematically showing a display unit of a display module according to some example embodiments. A display unit 11_1 may be configured to display an image in the display module 11.

Referring to FIG. 5, in addition to FIGS. 1 to 4, the display panel 100 may include the display area DA and the non-display area NDA.

In the display area DA, the pixels PX and wires electrically connected to the pixels PX may be located. The wires of the display area DA may include gate lines GL (e.g., scan lines), data lines DL, and a power line PL.

The gate lines GL may be arranged in the first direction DR1 in the display area DA and each may extend in the second direction DR2. Each of the gate lines GL may be electrically connected to the pixels PX arranged in the second direction DR2. The gate lines GL may be electrically connected between each of the pixels PX and a gate driver GD.

The data lines DL may be arranged in the second direction DR2 intersecting the first direction DR1 in the display area DA, and each may extend in the first direction DR1. Each of the data line DL may be electrically connected to the pixels PX arranged in the first direction DR1. The data lines DL may be electrically connected between each of the pixels PX and the display driver 200.

The power line PL may be commonly connected to the pixels PX. In some example embodiments, when the display driver 200 includes a power supply unit that generates a driving voltage for the pixels PX, the power line PL may be electrically connected between the pixels PX and the display driver 200. In some example embodiments, when the power supply unit is electrically connected to the display panel 100 through the pad portion PA, the power line PL may be located between the pixels PX and at least one display electrode pad DP (e.g., a first power pad for transmitting a first driving voltage to the pixels PX).

Respective gate signals, respective data voltages, and a driving voltage may be applied to the pixels PX through the gate lines GL, the data lines DL, and the power line PL. Each of the pixels PX may emit light with a luminance in response to each of data voltages.

The gate driver GD, the display driver 200, gate control lines GCL, and first connection lines DCL may be located in the non-display area NDA. Additionally, portions of the gate lines GL and portions of the data lines DL (or data connection lines connected to the data lines DL) may be further located in the non-display area NDA.

The gate driver GD may be connected to the display driver 200 via the gate control lines GCL and may receive gate control signals. For example, the display driver 200 includes a timing controller that controls the gate driver GD and the data driver, and the gate driver GD may receive gate control signals from the timing controller through the gate control lines GCL. The gate driver GD may generate gate signals (e.g., scan signals) in response to gate control signals and may output the generated gate signals to the gate lines GL.

In some example embodiments, the gate driver GD may be inside (e.g., the backplane layer 120) of the display panel 100 together with the pixels PX. Although FIG. 5 illustrates some example embodiments in which two gate drivers GD are located on opposite sides of the display area DA, the example embodiments are not limited thereto. For example, the display unit 11_1 may include a single gate driver GD located on one side of the display area DA or may include more than two gate drivers GD. In some example embodiments, the gate driver GD may be encapsulated by the encapsulation layer 140 together with the pixels PX, but is not limited thereto.

The display driver 200 may be electrically connected to the display electrode pads DP of a display pad area DPA through the first connection lines DCL and may receive digital video data and timing signals. The display driver 200 may convert digital video data into data voltages and output them to the data lines DL. In addition, the display driver 200 may generate gate control signals for controlling the gate driver GD based on timing signals and may output the gate control signals to the gate control lines GCL.

The operation timing of the pixels PX may be controlled by gate signals generated from the gate driver GD in response to gate control signals. Additionally, the light emitting luminance of the pixels PX may be controlled by data voltages outputted from the display driver 200.

The non-display area NDA may include the pad portion PA. For example, the non-display area NDA may include the pad portion PA positioned at one end of the display panel 100.

The pad portion PA may include the display pad area DPA. The display pad area DPA may include the display electrode pads DP for electrically connecting the display unit 11_1 to the circuit board 300. The display electrode pads DP may be electrically connected to some of the connection pads of the circuit board 300 that are joined (e.g., bonded) onto the pad portion PA of the display panel 100. For example, among the connection pads located in the pad portion of the circuit board 300, the connection pads that transmit driving signals and/or driving voltages for driving the display unit 11_1 to the display panel 100 may be joined onto the display electrode pads DP and be electrically connected to the display electrode pads DP, respectively.

The display electrode pads DP may be electrically connected to the pixels PX and/or the display driver 200 and transmit driving signals and driving voltages to drive the pixels PX to the pixels PX and/or the display driver 200. For example, when the display driver 200 is located on the substrate 110 of the display panel 100, at least some of the display electrode pads DP may be electrically connected to the display driver 200 and may transmit driving signals and driving voltages for the operation of the display driver 200 to the display driver 200. Accordingly, the display driver 200 may output driving signals (e.g., data voltages) for the operation of the pixels PX. In some example embodiments, when driving voltages (e.g., a first driving voltage of high potential and a second driving voltage of low potential) of the pixels PX are transmitted to the display panel 100 through the pad portion PA of the display panel 100, some of the display electrode pads DP may be electrically connected to the pixels PX and transmit the driving voltages to the pixels PX.

FIG. 6 is a plan view schematically showing a touch sensing unit of a display module according to some example embodiments. FIG. 7 is a plan view schematically showing a touch sensing unit of a display module according to some example embodiments. A touch sensing unit 11_2 may be configured to sense a touch input in the display module 11 and may constitute a touch sensing module together with the touch driver 400 (see FIG. 2). FIGS. 6 and 7 illustrate different embodiments with respect to configuration and/or placement of sensor lines TSL of the touch sensing unit 11_2.

Referring to FIGS. 6 and 7 in addition to FIGS. 1 to 4, the touch sensing unit 11_2 may include a touch sensing area TSA that may sense a touch input by a user and a peripheral area NSA located around the touch sensing area TSA. The peripheral area NSA may correspond to a non-sensing area in which a touch input is not sensed.

In some example embodiments, the touch sensing area TSA may correspond to the display area DA of the display unit 11_1, and the peripheral area NSA may correspond to the non-display area NDA of the display unit 11_1. For example, the touch sensing area TSA and the display area DA may be substantially the same area, and the peripheral area NSA and the non-display area NDA may be substantially the same area.

The sensor electrodes TSE and the sensor lines TSL electrically connected to the sensor electrodes TSE may be located in the touch sensing area TSA. In some example embodiments, the sensor electrodes TSE may be touch sensor electrodes that constitute the self-capacitive touch sensor and may be individually located at positions corresponding to respective touch nodes. For example, the sensor electrodes TSE may be arranged separately from each other in the touch sensing area TSA along the first direction DR1 and the second direction DR2. Each of the sensor electrodes TSE may operate as an independent touch node.

The sensor lines TSL may be electrically connected to the sensor electrodes TSE, respectively. For example, the sensor lines TSL may be touch sensor lines individually connected to the sensor electrodes TSE, and the sensor electrodes TSE and the sensor lines TSL may be referred to as connected in a 1:1 configuration.

The sensor lines TSL may be located around the sensor electrodes TSE or may overlap the sensor electrodes TSE. For example, at least some (one or more) of the sensor lines TSL may pass through an area in which a plurality of sensor electrodes TSE are located, as illustrated in FIG. 6 and may overlap the plurality of sensor electrodes TSE. Alternatively, as illustrated in FIG. 7, the sensor lines TSL may be located between and/or around the sensor electrodes TSE such that the overlap between the sensor electrodes TSE and the sensor lines TSL is minimized or limited. At portions (e.g., contact portions) where the respective sensor electrode TSE and sensor line TSL are connected, the respective sensor electrode TSE and sensor line TSL may overlap, for example, may locally overlap. The position, shape, and/or arrangement order of the sensor lines TSL are not limited to the example embodiments of FIGS. 6 and 7 and may be different for different embodiments of the touch sensing unit 11_2.

In some example embodiments, the sensor electrodes TSE and portions of the sensor lines TSL may be located or formed on the encapsulation layer 140. Another portion of the sensor lines TSL is located in a portion (e.g., the sub-region SBA of FIGS. 2 to 4) where the encapsulation layer 140 is not located and may be formed inside the backplane layer 120 or above the backplane layer 120.

A selector TMX and second connection lines TCL electrically connected to the selector TMX may be located in the peripheral area NSA. Additionally, portions of the sensor lines TSL (or sensor connection lines connected to the sensor lines TSL) may be further located in the peripheral area NSA. In some example embodiments, portions of the selector TMX, the second connection lines TCL, and the sensor lines TSL may be located on the substrate 110 and may be formed within the backplane layer 120 or above the backplane layer 120.

The selector TMX may be electrically connected to the sensor electrodes TSE via the sensor lines TSL. The selector TMX may include switches electrically connected to the respective sensor lines TSL. For example, the selector TMX may be formed as a multiplexer including switches for selectively connecting the plurality of sensor electrodes TSE included in each of a plurality of sensor electrode groups to a single touch electrode pad TP.

FIGS. 6 and 7 illustrate some example embodiments in which two selectors TMX are located in different portions of the peripheral area NSA and one or more sensor electrode groups, each including the plurality of sensor electrodes TSE, are connected to different selectors TMX. However, the number and/or positions of selectors TMX included in the touch sensing unit 11_2 may be varied depending on application and/or design.

The selector TMX may be electrically connected to the touch electrode pads TP of a touch pad area TPA via the second connection lines TCL. The selector TMX may receive selection signals from the touch driver 400 through the touch electrode pads TP, and in response to the selection signals, may electrically connect one of a plurality of sensor lines TSL connected to the plurality of sensor electrodes TSE to each of the touch electrode pads TP (e.g., each channel pad connected to each channel of the touch driver 400).

The peripheral area NSA may include the pad portion PA. For example, the peripheral area NSA may include the pad portion PA positioned at one end of the display panel 100.

The pad portion PA may include the touch pad area TPA. The touch pad area TPA may include the touch electrode pads TP for electrically connecting the touch sensing unit 11_2 to the circuit board 300. The touch electrode pads TP may be electrically connected to the connection pads of the circuit board 300, which are electrically connected to the touch sensing unit 11_2, among the connection pads that are connected to the pad portion PA of the display panel 100. For example, among the connection pads located in the pad area of the circuit board 300, the connection pads forming an electrical interface between the touch sensing unit 11_2 and the circuit board 300 for transmitting control signals (e.g., selection signals inputted to the selector TMX) for driving the touch sensing unit 11_2, driving signals (e.g., touch driving signals applied to the sensor electrodes TSE), and/or sensing signals (e.g., touch sensing signals detected from the sensor electrodes TSE) may be connected to the touch electrode pads TP and be electrically connected to the touch electrode pads TP, respectively.

In some example embodiments, the pad portion PA may further include the display pad area DPA of FIG. 5, and the touch pad area TPA may be located around the display pad area DPA. For example, the touch pad area TPA may be located on opposite sides of the display pad area DPA, or may be located on only one side of the display pad area DPA. FIGS. 6 and 7 illustrate the touch sensing unit 11_2 including two touch pad areas TPA spaced apart from each other. The display pad area DPA may be interposed between the two touch pad areas TPA.

The display electrode pads DP (see FIG. 5) and the touch electrode pads TP may constitute an electrical interface between the display panel 100 and the circuit board 300 and may also be collectively referred to as "electrode pads" located on the side of the display panel 100. For example, the display panel 100 may include electrode pads located in the pad portion PA, and the electrode pads of the display panel 100 may include the display electrode pads DP and the touch electrode pads TP.

The sensor electrodes TSE may be electrically connected to the touch driver 400 (see FIG. 2) via the sensor lines TSL, the selector TMX and the touch electrode pads TP. The touch driver 400 may supply touch driving signals to the sensor electrodes TSE and may detect a touch input by sensing the amount of change in capacitance formed on the sensor electrodes TSE. When each sensor electrode TSE is electrically connected to the touch driver 400 through one touch electrode pad TP, the period during which a touch driving signal is inputted and the period during which a sensing signal is outputted with respect to each of the sensor electrodes TSE may be temporally separated.

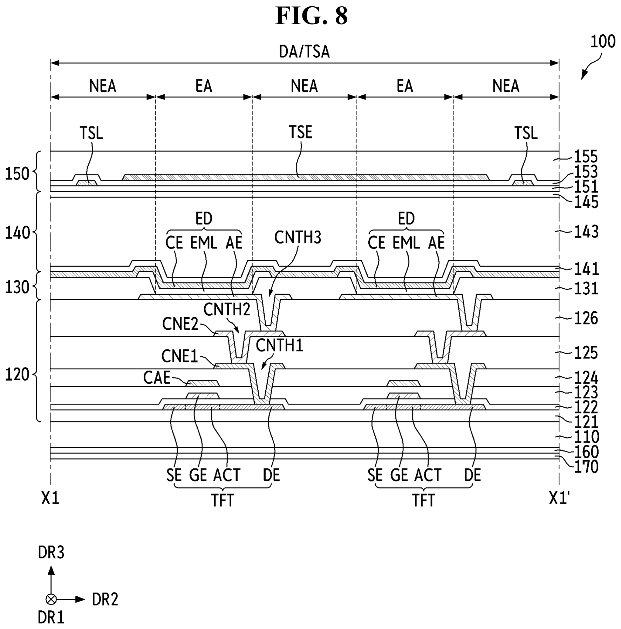

FIG. 8 is a cross-sectional view illustrating a display area of a display panel according to some example embodiments. For example, FIG. 8 schematically illustrates a cross-section of a portion of a display panel 100 taken along line X1-X1' of FIG. 2. FIG. 8 illustrates some example embodiments of a cross-section of a portion of the display area DA including two pixels PX and one sensor electrode TSE located on the two pixels PX.

Referring to FIG. 8 in addition to FIGS. 1 to 7, the display panel 100 may include the substrate 110, the backplane layer 120, the light emitting element layer 130, the encapsulation layer 140, and the touch sensing layer 150. In some example embodiments, the display panel 100 may further include an adhesive layer 160 located below the substrate 110, and a lower film 170 (e.g., a lower protective film) attached to the bottom surface of the substrate 110 via the adhesive layer 160.

The substrate 110 may include a material such as a polymer resin, glass, or metal. The substrate 110 may be formed as a single layer or multiple layers and may have flexible or rigid properties.

The backplane layer 120 may include circuit elements included in each of the pixels PX and a plurality of insulating layers. For example, the backplane layer 120 may include a thin film transistor TFT included in each of the pixels PX, and a buffer layer 121, a gate insulating layer 122, a first interlayer insulating layer 123, a second interlayer insulating layer 124, a first planarization insulating layer 125, and a second planarization insulating layer 126 sequentially located on the substrate 110.

The backplane layer 120 may further include connection electrodes. For example, the backplane layer 120 may include a first connection electrode CNE1 and a second connection electrode CNE2 electrically connected to the thin film transistor TFT of each of the pixels PX.

In some example embodiments, the buffer layer 121 may be located on the substrate 110. The thin film transistor TFT may be located on the buffer layer 121.

The thin film transistor TFT may include an active layer ACT (or channel region), a gate electrode GE, a source electrode SE (or source region), and a drain electrode DE (or drain region). The active layer ACT of the thin film transistor TFT may include polycrystalline silicon (e.g., low-temperature polycrystalline silicon), single crystal silicon, amorphous silicon, or oxide semiconductor. The active layer ACT overlapping the gate electrode GE in the third direction DR3, which is the thickness direction of the substrate 110, may be defined as a channel region. The source electrode SE and the drain electrode DE may be regions that do not overlap the gate electrode GE in the third direction DR3 and may have conductivity by doping a silicon semiconductor or an oxide semiconductor with ions or impurities.

The gate insulating layer 122 may be located on a semiconductor pattern of the thin film transistor TFT including the active layer ACT. The gate insulating layer 122 may cover the buffer layer 121, the active layer ACT of the thin film transistor TFT, and the like and may insulate the active layer ACT and the gate electrode GE.

The gate electrode GE may be located on the gate insulating layer 122. The gate electrode GE may overlap (e.g., vertically overlap) the active layer ACT while the gate insulating layer 122 is interposed between the gate electrode GE and the active layer ACT.

The first interlayer insulating layer 123 may be located on the gate electrode GE, and a capacitor electrode CAE may be located on the first interlayer insulating layer 123. In some example embodiments, when the gate electrode GE of the thin film transistor TFT is electrically connected to the capacitor, the capacitor electrode CAE may overlap the gate electrode GE of the thin film transistor TFT in the third direction DR3. The first interlayer insulating layer 123 may be located between the capacitor electrode CAE and the gate electrode GE, and a capacitor may be formed by the capacitor electrode CAE, the gate electrode GE, and the first interlayer insulating layer 123. When the gate electrode GE of the thin film transistor TFT is not directly connected to the capacitor, the capacitor electrode CAE may not overlap the gate electrode GE of the thin film transistor TFT and may overlap another capacitor electrode (e.g., a capacitor electrode located in the same layer as the gate electrode GE of the thin film transistor TFT) to form a capacitor.

The gate electrode GE and capacitor electrode CAE may include conductive materials. For example, each of the gate electrode GE and the capacitor electrode CAE may include a metal layer including at least one metal including molybdenum (Mo), aluminum (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), copper (Cu), a combination thereof and the like.

The second interlayer insulating layer 124 may be located on the first interlayer insulating layer 123 and the capacitor electrode CAE. The gate insulating layer 122, the first interlayer insulating layer 123, and the second interlayer insulating layer 124 may include or otherwise define a first contact hole CNTH1 through which the first connection electrode CNE1 passes.

Each of the buffer layer 121, the gate insulating layer 122, the first interlayer insulating layer 123, and the second interlayer insulating layer 124 may include at least one inorganic insulating layer including an inorganic material. For example, each of the buffer layer 121, the gate insulating layer 122, the first interlayer insulating layer 123, and the second interlayer insulating layer 124 may include silicon nitride, silicon oxide, silicon oxynitride, titanium oxide, aluminum oxide, or another inorganic insulating material.

The first connection electrode CNE1 may be located on the second interlayer insulating layer 124. The first connection electrode CNE1 may electrically connect the drain electrode DE of the thin film transistor TFT to the second connection electrode CNE2. The first connection electrode CNE1 may be electrically connected to the drain electrode DE of the thin film transistor TFT through the first contact hole CNTH1 formed in the first interlayer insulating layer 123, the second interlayer insulating layer 124, and the gate insulating layer 122. For example, a portion of the first connection electrode CNE1 may be located within the first contact hole CNTH1 and be in contact with the drain electrode DE of the thin film transistor TFT.

The first planarization insulating layer 125 may be located on the second interlayer insulating layer 124 and the first connection electrode CNE1. The first planarization insulating layer 125 may include a second contact hole CNTH2 through which the second connection electrode CNE2 passes.

The second connection electrode CNE2 may be located on the first planarization insulating layer 125. The second connection electrode CNE2 may electrically connect the first connection electrode CNE1 to the first electrode AE. The second connection electrode CNE2 may be electrically connected to the first connection electrode CNE1 through the second contact hole CNTH2 formed in the first planarization insulating layer 125.

The second planarization insulating layer 126 may be located on the first planarization insulating layer 125 and the second connection electrode CNE2. The second planarization insulating layer 126 may include a third contact hole CNTH3 through which the first electrode AE of the light emitting element ED passes.

Each of the first planarization insulating layer 125 and the second planarization insulating layer 126 may include an organic insulating layer including an organic material (e.g., an acrylic resin, an epoxy resin, a phenolic resin, a polyamide resin, a polyimide resin, or another organic insulating material). The first planarization insulating layer 125 and the second planarization insulating layer 126 may alleviate or reduce or flatten the step caused by circuit elements, connection electrodes, and/or wires of the backplane layer 120.

The light emitting element layer 130 may be located on the backplane layer 120. For example, the light emitting element layer 130 may be located on the second planarization insulating layer 126.

The light emitting element layer 130 may include the light emitting elements ED of the pixels PX. For example, the light emitting element layer 130 may include a pixel defining film 131 for partitioning the emission area EA of each of the pixels PX and the light emitting element ED located in each emission area EA. In some example embodiments, the light emitting element layer 130 may further include a spacer located on a portion of the pixel defining film 131.

The light emitting element ED may include the first electrode AE, a light emitting layer EML, and a second electrode CE sequentially located on the backplane layer 120. For example, the first electrode AE of the light emitting element ED may be located on the second planarization insulating layer 126 corresponding to each of the emission areas EA, and the light emitting layer EML and the second electrode CE may be sequentially stacked on the first electrode AE. In some example embodiments, the first electrode AE and the second electrode CE of the light emitting element ED may be an anode electrode and a cathode electrode, respectively.

In some example embodiments, the light emitting element ED may further include at least one intermediate layer. For example, the light emitting element ED may further include a first intermediate layer (e.g., a hole injection layer and/or a hole transport layer) interposed between the first electrode AE and the light emitting layer EML, and a second intermediate layer (e.g., an electron transport layer) interposed between the light emitting layer EML and the second electrode CE. In some example embodiments, at least one intermediate layer may be a common layer formed over the entire display area DA.

The first electrode AE of the light emitting element ED may be electrically connected to at least one circuit element included in the corresponding pixel PX. For example, the first electrode AE of the light emitting element ED may be electrically connected to a second connection electrode CNE2 through the second planarization insulating layer 126 and may be electrically connected to the thin film transistor TFT through the first connection electrode CNE1 through the gate insulating layer 122, the first interlayer insulating layer 123 and the second interlayer insulating layer 124, and the second connection electrode CNE2 through the first planarization insulating layer 125.

The first electrode AE of the light emitting element ED may include at least one conductive material and may be formed as a single layer or multiple layers. It may be a single-layer or multilayer electrode including at least one conductive material. In some example embodiments, the display panel 100 may be a top emission type display panel, and the first electrode AE may include a reflective electrode layer having high reflectivity.

The light emitting layer EML of the light emitting element ED may include an organic material and may emit light of a desired color (or a desired wavelength band). For example, the light emitting layer EML may emit red light, green light, blue light, white light, or other colors of light. Light emitted from the light emitting layer EML may contribute to image display.

The light emitting layer EML may be formed individually in each of the emission areas EA or may be formed in the form of a common layer across the entire display area DA. For example, the light emitting layer EML may be individually located in the emission area EA of each of the pixels PX and may emit light of a color (e.g., red light, green light, or blue light) corresponding to the emission color (or emission wavelength) of each of the pixels PX. Alternatively, the light emitting layer EML may be located across the entire display area DA including the emission areas EA of the pixels PX and may emit light of a desired color (e.g., blue light or white light). When the light emitting layer EML emits light of a color different from the emission color (or emission wavelength) of the corresponding pixel PX, a light conversion layer and/or a color filter layer to convert the color (or wavelength) of the light emitted from the light emitting element ED into light corresponding to the emission wavelength of the corresponding pixel PX may be located on the light emitting element ED of at least one pixel PX.

The second electrode CE of the light emitting element ED may include a conductive material. In some example embodiments, the second electrode CE of the light emitting element ED may be a common layer formed across the entire display area DA to cover the light emitting layer EML and the pixel defining film 131. In some example embodiments, the second electrode CE of the light emitting element ED may include transparent conductive oxide (TCO) such as ITO or IZO configured to transmit light or a semi-transmissive conductive material such as magnesium (Mg), silver (Ag), or an alloy of magnesium (Mg) and silver (Ag).

The pixel defining film 131 may have an opening corresponding to each of the emission areas EA and may surround the emission areas EA. For example, the pixel defining film 131 may cover an edge of the first electrode AE of the light emitting element ED and may include an opening exposing a portion of the first electrode AE. A region where the exposed first electrode AE and the light emitting layer EML overlap may be defined as the emission area EA of each pixel PX.

In some example embodiments, the pixel defining film 131 may include an organic insulating material. For example, the pixel defining film 131 may include acrylic resin, epoxy resin, phenolic resin, polyamide resin, polyimide resin, unsaturated polyester resin, polyphenylene ether resin, polyphenylene sulfide resin, benzocyclobutene (BCB), or other organic insulating materials.

The encapsulation layer 140 may be located on the light emitting element layer 130. The encapsulation layer 140 may cover the light emitting element layer 130 in the display area DA and may extend to the non-display area NDA to be in contact with the backplane layer 120. For example, the encapsulation layer 140 may be located in the display area DA to cover the light emitting element layer 130, and the end of the encapsulation layer 140 may be located in a portion of the non-display area NDA adjacent to the display area DA. The encapsulation layer 140 may block or limit or reduce the permeation of oxygen or moisture into the light emitting element layer 130, and may mitigate electrical and/or physical impacts to the backplane layer 120 and the light emitting element layer 130.

In some example embodiments, the encapsulation layer 140 may be formed as multiple layers including an inorganic encapsulation layer and an organic encapsulation layer. For example, the encapsulation layer 140 may include a first inorganic encapsulation layer 141, an organic encapsulation layer 143, and a second inorganic encapsulation layer 145 sequentially arranged on the light emitting element layer 130. The encapsulation layer 140 may be replaced by an encapsulation member of a different type, structure, and/or material. For example, the light emitting element layer 130 may be encapsulated using an upper substrate including an insulating material such as glass, or a protective layer including a single or multilayer capping layer.

The touch sensing layer 150 may be located on the encapsulation layer 140. The touch sensing layer 150 may include the sensor electrodes TSE and the sensor lines TSL. FIG. 8 illustrates one sensor electrode TSE and two sensor lines TSL located around the sensor electrode TSE. The one sensor electrode TSE may be electrically connected to one sensor line TSL.

The touch sensing layer 150 may further include a plurality of insulating layers. For example, the touch sensing layer 150 may include a first sensor insulating layer 151, a second sensor insulating layer 153, and a protective layer 155 (e.g., a passivation layer or an overcoat layer) sequentially located on the encapsulation layer 140.

The first sensor insulating layer 151 may be located or formed on the encapsulation layer 140. The first sensor insulating layer 151 may include at least one inorganic insulating layer containing an inorganic material. In some example embodiments, the first sensor insulating layer 151 may be omitted.

The sensor lines TSL may be located on the first sensor insulating layer 151 (or the encapsulation layer 140 when the first sensor insulating layer 151 is omitted). The sensor lines TSL include a conductive material and may be transparent or opaque. For example, the sensor lines TSL may include at least one of molybdenum (Mo), aluminum (Al), chromium (Cr), gold (Au), silver (Ag), titanium (Ti), nickel (Ni), neodymium (Nd), copper (Cu), or another metal, an alloy thereof, or a transparent conductive material such as ITO and IZO. When the sensor lines TSL are opaque, the sensor lines TSL may be located in a non-emission area NEA. The non-emission area NEA may be positioned around the emission areas EA of the pixels PX and may surround the emission areas EA.

The second sensor insulating layer 153 may be located on the first sensor insulating layer 151 and the sensor lines TSL. The second sensor insulating layer 153 may include at least one inorganic insulating layer containing an inorganic material.

The sensor electrodes TSE may be located on the second sensor insulating layer 153. The sensor electrodes TSE include a conductive material and may be transparent or opaque. For example, the sensor electrodes TSE may include at least one of molybdenum (Mo), aluminum (Al), chromium (Cr), gold (Au), silver (Ag), titanium (Ti), nickel (Ni), neodymium (Nd), copper (Cu), and another metal, an alloy thereof, or a transparent conductive material such as ITO and IZO. In some example embodiments, the sensor electrodes TSE may be substantially transparent and overlap the light emitting elements ED. For example, at least a portion of the sensor electrodes TSE may be located in the emission areas EA of the pixels PX.

Although FIG. 8 illustrates the sensor lines TSL and the sensor electrodes TSE being located on the first sensor insulating layer 151 and the second sensor insulating layer 153, respectively, the positions of the sensor lines TSL and/or the sensor electrodes TSE may be changed as per application and/or design. For example, in some example embodiments, the sensor electrodes TSE may be located or formed on the first sensor insulating layer 151, and the sensor lines TSL may be located or formed on the second sensor insulating layer 153.

The protective layer 155 may be located or formed on the second sensor insulating layer 153 and the sensor electrodes TSE. The protective layer 155 may include at least one insulating layer including an inorganic insulating material and/or an organic insulating material.

In some example embodiments, the touch sensing layer 150 may be formed integrally with the display panel 100. For example, the sensor electrodes TSE and portions of the sensor lines TSL may be formed on the encapsulation layer 140 covering the pixels PX, and other portions of the sensor lines TSL may be formed on the substrate 110 and/or the backplane layer 120.

In some example embodiments, the display device 1 may further include additional elements located on the touch sensing layer 150. For example, the display device 1 may further include at least one of an optical layer (e.g., an anti-reflection layer including a polarizing layer and/or a color filter layer) or a protective layer (e.g., a window or a protective film) located on the touch sensing layer 150. In some example embodiments, the optical layer and/or the passivation layer may be provided on the display panel 100. For example, the optical layer and/or the passivation layer may be formed on the touch sensing layer 150 and may be manufactured integrally with the display panel 100. In some example embodiments, the optical layer and/or the passivation layer may be manufactured separately from the display panel 100 and attached to the display panel 100 via an adhesive layer or the like.

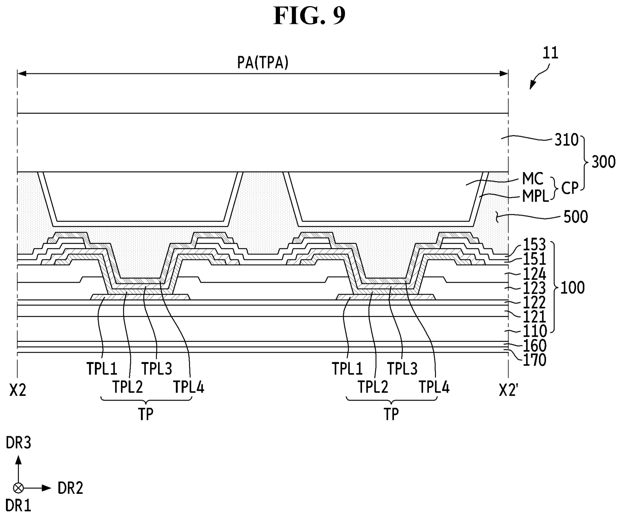

FIG. 9 is a cross-sectional view illustrating a pad portion of a display module according to some example embodiments. For example, FIG. 9 schematically illustrates a cross-section of a portion of the pad portion PA corresponding to line X2-X2' of FIG. 2.

FIG. 9 illustrates a cross-section of a portion of the touch pad area TPA including two touch electrode pads TP located on the side of the display panel 100 and two connection pads CP located on the side of the circuit board 300 and bonded onto the two touch electrode pads TP. The touch pad area TPA and the display pad area DPA may have substantially the same or similar cross-sectional structures.

Referring to FIG. 9 in addition to FIGS. 1 to 8, the display panel 100 may include the display electrode pads DP located in the display pad area DPA and touch electrode pads TP located in the touch pad area TPA. Each of the display electrode pads DP and the touch electrode pads TP may be located on the substrate 110 and may be formed with a pattern of at least one conductive layer among the conductive layers included in the display panel 100.

In some example embodiments, each of the touch electrode pads TP may be formed as multiple layers. For example, each of the touch electrode pads TP may include a first electrode layer TPL1, and a second electrode layer TPL2, a third electrode layer TPL3, and a fourth electrode layer TPL4 sequentially located on the first electrode layer TPL1.

The first electrode layer TPL1 may be located on the gate insulating layer 122. The gate electrode GE and the first electrode layer TPL1 of the thin film transistor TFT included in the pixel PX may be formed simultaneously and may include the same conductive material.

The first interlayer insulating layer 123 and the second interlayer insulating layer 124 may be opened on at least a portion of the first electrode layer TPL1 and expose the first electrode layer TPL1. In some example embodiments, the first interlayer insulating layer 123 and the second interlayer insulating layer 124 may cover an edge portion of the first electrode layer TPL1.

The second electrode layer TPL2 may be located on the second interlayer insulating layer 124. The second electrode layer TPL2 may be in contact with the first electrode layer TPL1 at the opened portion of the second interlayer insulating layer 124. The first connection electrode CNE1 and the second electrode layer TPL2 included in the pixel PX may be formed simultaneously and may include the same conductive material.

The first planarization insulating layer 125 may not be formed in the pad portion PA. For example, the second electrode layer TPL2 may not be covered with the first planarization insulating layer 125.

The third electrode layer TPL3 may be located on the second electrode layer TPL2. The second connection electrode CNE2 and the third electrode layer TPL3 included in the pixel PX may be formed simultaneously and may include the same conductive material.

The second planarization insulating layer 126 may not be formed in the pad portion PA. For example, the third electrode layer TPL3 may not be covered by the second planarization insulating layer 126. In some example embodiments, during the process of forming the second planarization insulating layer 126, a cladding layer covering an end of the third electrode layer TPL3 may be formed.

The first sensor insulating layer 151 and the second sensor insulating layer 153 may be opened on at least a portion of the third electrode layer TPL3 and expose the third electrode layer TPL3. In some example embodiments, the first sensor insulating layer 151 and the second sensor insulating layer 153 may cover an edge portion of the third electrode layer TPL3.

The fourth electrode layer TPL4 may be located on the first sensor insulating layer 151 and the second sensor insulating layer 153. The fourth electrode layer TPL4 may be in contact with the third electrode layer TPL3 at the opened portions of the first sensor insulating layer 151 and the second sensor insulating layer 153. The sensor electrode TSE of the touch sensing area TSA and the fourth electrode layer TPL4 of the pad portion PA may be formed simultaneously and may include the same conductive material.

The structure of the touch electrode pad TP may be changed as per application and/or design. For example, the touch electrode pad TP may include only some of the first electrode layer TPL1, the second electrode layer TPL2, the third electrode layer TPL3, and the fourth electrode layer TPL4 or may further include additional electrode layer(s).

The electrode pads of the pad portion PA may be formed simultaneously. For example, the display electrode pads DP of the display pad area DPA and the touch electrode pads TP of the touch pad area TPA may be formed simultaneously. The display electrode pads DP and the touch electrode pads TP may include the same material and may have the same or similar cross-sectional structure.

The electrode pads of the pad portion PA may be electrically connected to the connection pads CP of the circuit board 300. For example, the connection pads CP of the circuit board 300 may be bonded onto the electrode pads of the pad portion PA via an adhesive member 500. The adhesive member 500 may be an ACF including conductive particles but is not limited thereto.

The circuit board 300 may include a main body portion 310 and the connection pads CP located on one surface of the main body portion 310. A portion (e.g., the pad area of the circuit board 300) of the circuit board 300 in which the connection pads CP are located may face the pad portion PA of the display panel 100.

The main body portion 310 may include a base substrate and a circuit layer. The base substrate of the main body portion 310 may be made of a flexible film (e.g., a polyimide film).

The connection pads CP may be connected to the electrode pads (e.g., the display electrode pads DP and the touch electrode pads TP) of the display panel 100 via the adhesive member 500. The connection pads CP form electrical contacts with the electrode pads of the display panel 100.

In some example embodiments, the connection pads CP may protrude toward the electrode pads of the display panel 100 on one surface of the main body portion 310. For example, each of the connection pads CP may be bump-type pads including a metal core MC and a plating film MPL. Accordingly, a connection between the electrode pads of the display panel 100 and the connection pads CP of the circuit board 300 may be relatively more stable.

The metal core MC of the connection pad CP may be located on the pad portion PA of the display panel 100 and may protrude from one surface of the circuit board 300 toward the display panel 100. The metal core MC may include a low-resistivity conductive material (e.g., a metal with low electrical resistivity, such as copper (Cu)).

The plating film MPL of the connection pad CP may cover the surface of the metal core MC. The plating film MPL may include a material suitable for protecting the metal core MC, for example, a metal such as nickel (Ni). The metal core MC may be protected by the plating film MPL, and a contact failure may be reduced or limited.

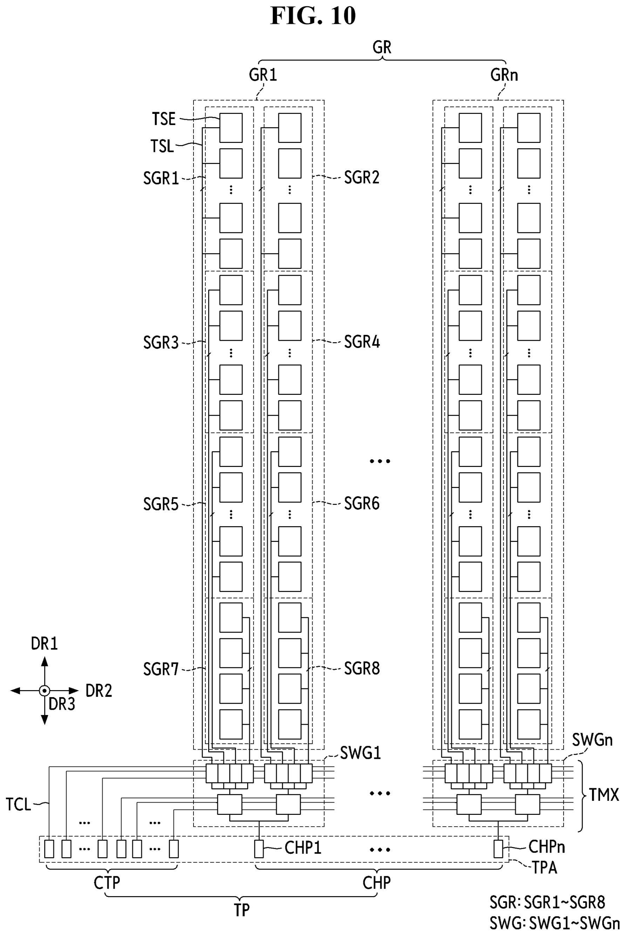

FIG. 10 is a diagram schematically illustrating a connection structure between sensor electrodes and touch electrode pads of a touch sensing unit according to some example embodiments.

Referring to FIG. 10, the sensor electrodes TSE may be divided into a plurality of groups GR. In some example embodiments, two adjacent columns of the sensor electrodes TSE in the second direction DR2 may form one group GR. For example, the sensor electrodes TSE of the first column and the sensor electrodes TSE of the second column may be grouped into a first group GR1. In some example embodiments, the sensor electrodes TSE of the N^{th} odd column and the sensor electrodes TSE of the N^{th} even column may form the N^{th} group GRn, where N is a natural number greater than or equal to 1. For example, when 30 columns of the sensor electrodes TSE are located in the touch sensing area TSA, the sensor electrodes TSE may be divided into 15 groups GR.

The sensor electrodes TSE of each of the groups GR may be divided into a plurality of sub-groups SGR. For example, the sensor electrodes TSE of each of the groups GR may be divided into the plurality of sub-groups SGR in the first direction DR1 and the second direction DR2.

In some example embodiments, the sensor electrodes TSE of each of the groups GR may be divided into the plurality of sub-groups SGR in a form corresponding to the waveform of the selection signal outputted from the touch driver 400. For example, when a selection signal having 12 pulses (e.g., pulses having 12 gate-on voltages) is outputted during one cycle (e.g., one driving cycle or one sensing cycle) from the touch driver 400, 12 sensor electrodes TSE may be grouped into one sub-group SGR based on the first direction DR1. In some example embodiments, the arrangement pattern and/or number of sensor electrodes TSE may be changed, without affecting the operation of the touch driver 400.

In some example embodiments, when the number of rows in which the sensor electrodes TSE are located is not a multiple of the reference number of sensor electrodes TSE included in each of the sub-groups SGR, the last sub-group SGR in the first direction DR1 may include a smaller number of sensor electrodes TSE than the other sub-groups SGR. For example, when 40 rows of the sensor electrodes TSE are located in the touch sensing area TSA, one column of the sensor electrodes TSE arranged in the first direction DR1 may be divided into three sub-groups (SGR1, SGR3, and SGR5, or SGR2, SGR4, and SGR6) each including 12 sensor electrodes TSE and one sub-group (SGR7 or SGR8) including 4 sensor electrodes TSE. For example, the sensor electrodes TSE of the first odd column (e.g., the first column) and the sensor electrodes TSE of the first even column (e.g., the second column) included in the first group GR1 may each include four sub-groups (SGR1, SGR3, SGR5, and SGR7, or SGR2, SGR4, SGR6, and SGR8). As a result, the sensor electrodes TSE of the N^{th} odd column and the sensor electrodes TSE of the N^{th} even column included in the N^{th} group GRn may each include four sub-groups SGR.

In some example embodiments, when the number of rows in which the sensor electrodes TSE are located is a multiple of the reference number of sensor electrodes TSE included in the sub-group SGR, the sub-groups SGR may include the same number of sensor electrodes TSE. For example, when the number of rows in which the sensor electrodes TSE are located is a multiple of 12, each of the sub-groups SGR may include 12 sensor electrodes TSE.

The selector TMX may be electrically connected to control pads CTP and channel pads CHP included in the touch electrode pads TP via the respective second connection lines TCL. The selector TMX may include a plurality of switches that are turned on and off in response to control signals (e.g., selection signals for selectively connecting the sensor electrodes TSE to the channel pads CHP) transmitted from the control pads CTP. For example, the selector TMX may include a plurality of multiplexers.

The selector TMX may include switch groups SWG for selectively connecting each group of sensor electrodes TSE to one touch electrode pad TP. For example, the selector TMX may include first to N^{th} switch groups SWG1 to SWGn for selectively connecting the sensor electrodes TSE of the first group GR1 to the N^{th} group GRn to first to n^{th} channel pads CHP1 to CHPn, respectively. The first to n^{th} channel pads CHP1 to CHPn may be electrically connected to each channel of the touch driver 400.

The touch electrode pads TP may include the first to nth channel pads CHP1 to CHPn electrically connected to the sensor electrodes TSE via the selector TMX, and the control pads CTP that transmit control signals to the selector TMX. Each of the channel pads CHP may be selectively connected to one group of sensor electrodes TSE by the selector TMX. Control signals inputted to the control pads CTP may be selection signals that control the operation of switches included in the selector TMX.

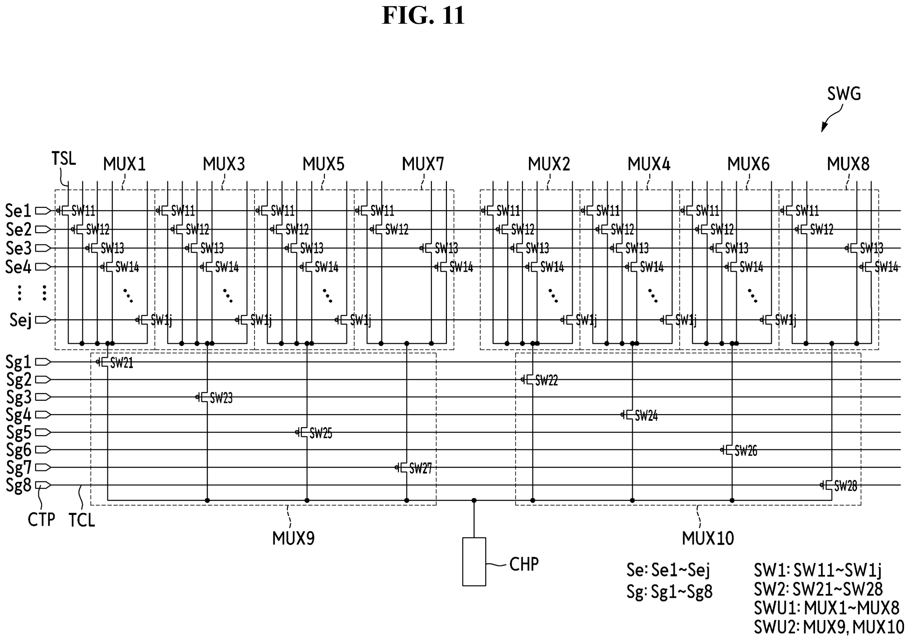

FIG. 11 is a diagram showing a selector of a touch sensing unit according to some example embodiments. For example, FIG. 11 illustrates one switch group SWG included in the selector TMX, according to some example embodiments.

Referring to FIG. 11 and in addition to FIG. 10, the sensor electrodes TSE of each group GR may be selectively connected to one channel pad CHP through one switch group SWG. Each switch group SWG may include a first group of multiplexers MUX1 to MUX8 for selecting the sensor electrodes TSE included in each sub-group SGR, and a second group of multiplexers MUX9 and MUX10 for selecting the first group of multiplexers MUX1 to MUX8.

In some example embodiments, the sensor electrodes TSE of each group GR may be divided into eight sub-groups SGR1 to SGR8. In some example embodiments, the multiplexers MUX1 to MUX8 of the first group may include the first multiplexer MUX1 including first switches SW1 electrically connected to the sensor electrodes TSE of the first sub-group SGR1, the second multiplexer MUX2 including the first switches SW1 electrically connected to the sensor electrodes TSE of the second sub-group SGR2, the third multiplexer MUX3 including the first switches SW1 electrically connected to the sensor electrodes TSE of the third sub-group SGR3, the fourth multiplexer MUX4 including the first switches SW1 electrically connected to the sensor electrodes TSE of the fourth sub-group SGR4, the fifth multiplexer MUX5 including the first switches SW1 electrically connected to the sensor electrodes TSE of the fifth sub-group SGR5, the sixth multiplexer MUX6 including the first switches SW1 electrically connected to the sensor electrodes TSE of the sixth sub-group SGR6, the seventh multiplexer MUX7 including the first switches SW1 electrically connected to the sensor electrodes TSE of the seventh sub-group SGR7, and the eighth multiplexer MUX8 including the first switches SW1 electrically connected to the sensor electrodes TSE of the eighth sub-group SGR8. The first group of multiplexers MUX1 to MUX8 may also be referred to as a first switch unit SWU1.

Each of the first to eighth multiplexers MUX1 to MUX8 may include the first switches SW1 individually connected to the sensor electrodes TSE included in each sub-group SGR. For example, the sensor electrodes TSE of each group GR may be connected one-to-one to the first switches SW1 included in the first to eighth multiplexers MUX1 to MUX8.

In some example embodiments, when each of the first to sixth sub-groups SGR1 to SGR6 includes J (e.g., twelve) sensor electrodes TSE, each of the first to sixth multiplexers MUX1 to MUX6 may include J first switches SW11 to SW1j, where J is a natural number greater than or equal to 1. For example, if each of the first to sixth sub-groups SGR1 to SGR6 includes twelve sensor electrodes TSE, each of the first to sixth multiplexers MUX1 to MUX6 may be a 12:1 multiplexer including twelve first switches SW1. The first switches SW1 may be turned on in response to respective electrode selection signals Se applied to corresponding gate electrodes.

The J first switches SW11 to SW1j included in each of the first to sixth multiplexers MUX1 to MUX6 may be sequentially turned on by the different electrode selection signals Se transmitted through the different control pads CTP. For example, the first switches SW11 to SW1j included in each of the first to sixth multiplexers MUX1 to MUX6 may be sequentially turned on by the first to J^{th} electrode selection signals Se1 to Sej.

FIG. 11 illustrates each of the control pads CTP transmitting the electrode selection signals Se as a directional input terminal to show that the electrode selection signals Se are inputted from the respective control pads CTP to the switch group SWG of the selector TMX. However, the control pads CTP transmitting the electrode selection signals Se may be formed in a shape substantially the same as or similar to each channel pad CHP and may be arranged in the touch pad area TPA together with the channel pads CHP.

In some example embodiments, when each of the seventh and eighth sub-groups SGR7 and SGR8 includes less than J sensor electrodes TSE, each of the seventh and eighth multiplexers MUX7 and MUX8 may include less than J first switches SW1. For example, if each of the seventh and eighth sub-groups SGR7 and SGR8 includes four sensor electrodes TSE, each of the seventh and eighth multiplexers MUX7 and MUX8 may be a 4:1 multiplexer including four first switches SW11 to SW14.

The four first switches SW11 to SW14 included in each of the seventh and eighth multiplexers MUX7 and MUX8 may be sequentially turned on by the different electrode selection signals Se. For example, the four first switches SW11 to SW14 included in each of the seventh and eighth multiplexers MUX7 and MUX8 may be sequentially turned on by the first to fourth electrode selection signals Se1 to Se4.

Although FIG. 11 illustrates the first switches SW1 being connected to the sensor electrodes TSE of the odd column and the first switches SW1 being connected to the sensor electrodes TSE of the even column share the electrode selection signals Se, example embodiments are not limited thereto. For example, the electrode selection signals Se for driving the first switches SW1 connected to the sensor electrodes TSE of the odd column may be separated from the electrode selection signals Se for driving the first switches SW1 connected to the sensor electrodes TSE of the even column.

The second group of multiplexers MUX9 and MUX10 may include the ninth multiplexer MUX9 and the tenth multiplexer MUX10. The ninth multiplexer MUX9 may include second switches SW2 that are connected to the multiplexers MUX1, MUX3, MUX5, and MUX7 connected to the sensor electrodes TSE of the odd column among the first group of the multiplexers MUX1 to MUX8. The tenth multiplexer MUX10 may include second switches SW2 that are connected to the multiplexers MUX2, MUX4, MUX6, and MUX8 connected to the sensor electrodes TSE of the even column among the first group of multiplexers MUX1 to MUX8. For example, the ninth multiplexer MUX9 may include second switches SW21, SW23, SW25, and SW27 that are connected to the first, third, fifth, and seventh multiplexers MUX1, MUX3, MUX5, and MUX7 connected to the sensor electrodes TSE of the first, third, fifth and seventh sub-groups SGR1, SGR3, SGR5, and SGR7, respectively. The tenth multiplexer MUX10 may include second switches SW22, SW24, SW26, and SW28 that are connected to the second, fourth, sixth, and eighth multiplexers MUX2, MUX4, MUX6, and MUX8 connected to the sensor electrodes TSE of the second, fourth, sixth, and eighth sub-groups SGR2, SGR4, SGR6, SGR8, respectively. In some example embodiments, each of the ninth multiplexer MUX9 and the tenth multiplexer MUX10 may be a 4:1 multiplexer. Although FIG. 11 illustrates the ninth multiplexer MUX9 and the tenth multiplexer MUX10 separately, the ninth multiplexer MUX9 and the tenth multiplexer MUX10 may be integrated into one multiplexer. For example, the ninth multiplexer MUX9 and the tenth multiplexer MUX10 may be integrated into an 8:1 multiplexer. The second group of multiplexers MUX9 and MUX10 may also be referred to as a second switch unit SWU2. The second switches SW2 may be turned on in response to the group selection signals Sg respectively applied to the gate electrodes.

The second switches SW2 may selectively connect the sensor electrodes TSE of each group GR to one channel pad CHP in response to each group selection signal Sg. For example, the second switches SW2 may be turned on by the different group selection signals Sg transmitted through the different control pads CTP according to the order in which the sensor electrodes TSE of each group GR are connected to one channel pad CHP. For example, the second switches SW2 may be turned on during different periods by the first to eighth group selection signals Sg1 to Sg8 inputted from the different control pads CTP.

For example, during each period in which each of the sensor electrodes TSE of the first sub-group SGR1 is selected, the second switch SW21 connected to the first multiplexer MUX1 may be turned on by the first group selection signal Sg1 (e.g., a selection signal for selecting the sensor electrodes TSE included in each of the first sub-groups SGR1) inputted from one control pad CTP. During each period in which each of the sensor electrodes TSE of the second sub-group SGR2 is selected, the second switch SW22 connected to the second multiplexer MUX2 may be turned on by the second group selection signal Sg2 (e.g., a selection signal for selecting the sensor electrodes TSE included in each of the second sub-groups SGR2) inputted from another control pad CTP. In the aforementioned manner, during each period in which each of the sensor electrodes TSE of the third to eighth sub-groups SGR3 to SGR8 is selected, the second switches SW23 to SW28 connected to the third to eighth multiplexers MUX3 to MUX8 may be turned on by the third to eighth group selection signals Sg3 to Sg8 inputted from the respective control pads CTP.

FIG. 11 illustrates each of the control pads CTP transmitting the group selection signals Sg as a directional input terminal to show that the group selection signals Sg are inputted from the respective control pads CTP. However, the control pads CTP for transmitting the group selection signals Sg may also be formed in a shape substantially the same as or similar to each channel pad CHP and may be arranged in the touch pad area TPA together with the channel pads CHP.

The position and arrangement order of the control pads CTP for transmitting each electrode selection signal Se and each group selection signal Sg into the display panel 100 may be changed as per application and/or design. In addition, a pair of the control pad CTP and the connection pad (the connection pad of the circuit board 300) for transmitting one electrode selection signal Se may be arranged at corresponding positions and joined to each other. Similarly, a pair of the control pad CTP and the connection pad (the connection pad of the circuit board 300) for transmitting one group selection signal Sg may be arranged at corresponding positions and joined to each other.

In some example embodiments, the number of first switches SW1 connected to one second switch SW2 may be different from the number of first switches SW1 connected to another second switch SW2. For example, when the number of first switches SW1 included in each of the seventh and eighth multiplexers MUX7 and MUX8 is less than the number of first switches SW1 included in each of the first to sixth multiplexers MUX1 to MUX6, each of the second switches SW27 and SW28 connected to the seventh and eighth multiplexers MUX7 and MUX8 may be electrically connected to a less number of first switches SW1 compared to the second switches SW21 to SW26 connected to the first to sixth multiplexers MUX1 to MUX6.

FIG. 11 shows a circuit configuration of the switch group SWG, according to some example embodiments, and the arrangement order or position of the first switches SW1 and second switches SW2 included in each switch group SWG may be different as per application and/or design. Similarly, the arrangement or order of the second connection lines TCL connected to the switch group SWG, for example, the second connection lines TCL that transmit the respective selection signals (e.g., the respective electrode selection signals Se and the respective group selection signals Sg) to the first switches SW1 and the second switches SW2, may be different as per application and/or design.

According to some example embodiments, the sensor electrodes TSE of each group GR may be electrically connected to one channel pad CHP by the selector TMX. Accordingly, the interface between the display panel 100 and the circuit board 300 may be simplified and the number of pads may be reduced.

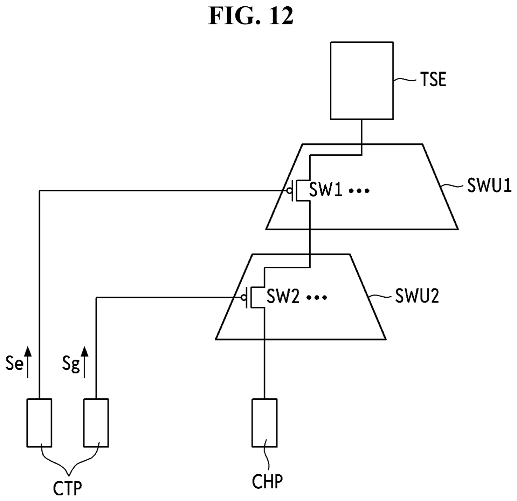

FIG. 12 schematically shows a connection structure between a sensor electrode and a channel pad according to some example embodiments. For example, FIG. 12 illustrates the connection structure between the sensor electrode TSE and the channel pad CHP with respect to one sensor electrode TSE.

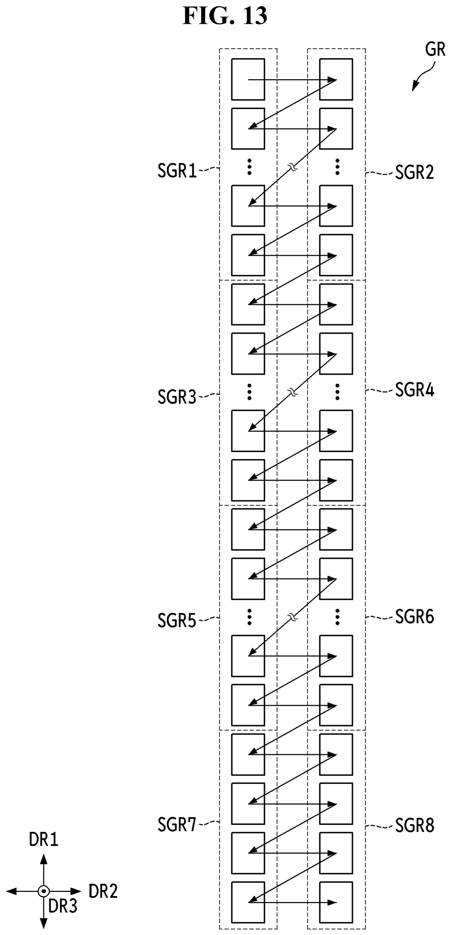

FIG. 13 is a diagram showing the selection order of sensor electrodes according to some example embodiments. For example, FIG. 13 shows some example embodiments of a method of sequentially selecting the sensor electrodes TSE of each group GR.

Referring to FIGS. 12 and 13, during each period in which each sensor electrode TSE is selected, the first switch SW1 and the second switch SW2 connected to the sensor electrode TSE may be turned on by each electrode selection signal Se and each group selection signal Sg. Accordingly, the sensor electrode TSE may be electrically connected to the channel pad CHP.

The period during which each sensor electrode TSE is selected may include a driving period for applying a driving signal to each sensor electrode TSE and a sensing period for detecting a change in capacitance formed at each sensor electrode TSE. In some example embodiments, a driving signal may be first applied to each sensor electrode TSE and then the change in capacitance may be detected.

In some example embodiments, the sensor electrodes TSE may be sequentially selected in the order corresponding to the moving directions of arrow in FIG. 13, and the sensor electrodes TSE may be electrically connected to the channel pads CHP, respectively. For example, during each driving period, the sensor electrodes TSE of each row may be selected in the order from the first row to the last row. In addition, the sensor electrode TSE of the odd column and the sensor electrode TSE of the even column may be selected sequentially. For example, even if the first switches SW1 connected to the first sensor electrodes SE of each sub-group SGR are turned on simultaneously by the first electrode selection signal Se1, only the first switch SW1 connected to one sensor electrode SE to be connected to one channel pad CHP may be electrically connected to the channel pad CHP by the group selection signal Sg.

The selection order of the sensor electrodes TSE is not limited to example embodiments of FIG. 13 and may be changed as per application and/or design. For example, the selection order of the sensor electrodes TSE may be appropriately adjusted or changed by controlling or modifying the selection signals (e.g., the electrode selection signals Se and the group selection signals Sg) inputted to the control pads CTP.

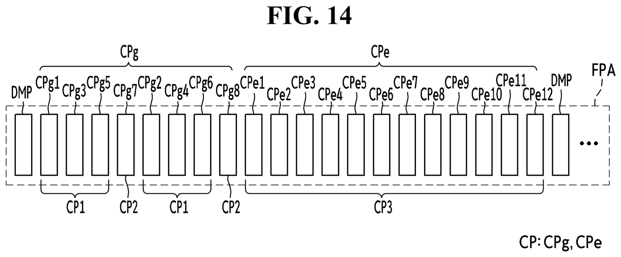

FIG. 14 shows a pad area of a circuit board according to some example embodiments. For example, FIG. 14 shows a part of a pad area FPA of the circuit board 300 where the connection pads CP to be joined to the control pads CTP (see FIG. 10) of the display panel 100 are arranged. The connection pads CP that are joined to the channel pads CHP and the display electrode pads DP of the display panel 100 may be further arranged in the pad area FPA of the circuit board 300.

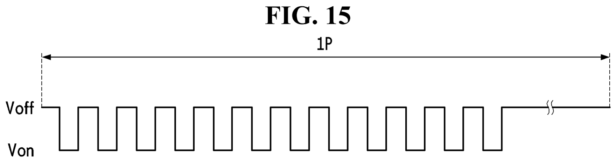

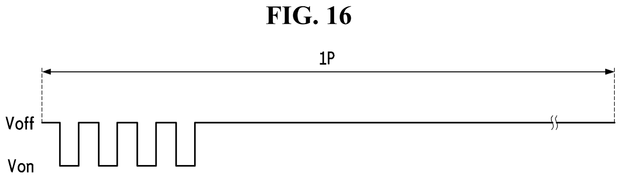

FIGS. 15 and 16 are waveform diagrams showing some example embodiments of group selection signals inputted to different second switches. For example, FIG. 15 schematically shows a waveform of one of the first to sixth group selection signals Sg1 to Sg6. FIG. 16 schematically shows a waveform of one of the seventh and eighth group selection signals Sg7 and Sg8.

Referring to FIGS. 14 to 16 and in addition to FIGS. 1 to 13, the circuit board 300 may include the connection pads CP for transmitting respective control signals to the control pads CTP among the touch electrode pads TP of the display panel 100. For example, the connection pads CP of the circuit board 300 may include first signal pads CPe transmitting respective electrode selection signals Se to the control pads CTP electrically connected to the first switches SW1 included in the selector TMX of the display panel 100, and second signal pads CPg transmitting respective group selection signals Sg to the control pads CTP electrically connected to the second switches SW2 included in the selector TMX of the display panel 100. For example, the first signal pads CPe may be joined (e.g., bonded) to the control pads CTP electrically connected to the gate electrodes of the first switches SW1 to transmit, to the control pads CTP, the respective electrode selection signals Se for controlling the on/off states of the first switches SW1. Further, the second signal pads CPg may be joined to the control pads CTP electrically connected to the gate electrodes of the second switches SW2 to transmit, to the control pads CTP, the respective group selection signals Sg for controlling the on/off states of the second switches SW2.

In some example embodiments, dummy pads DMP may be located adjacent to the first signal pads CPe and the second signal pads CPg.

In some example embodiments, among the connection pads CP, the connection pads CP to which similar or substantially the same level voltages are applied may be arranged adjacent to each other. For example, among the connection pads CP, the connection pads CP to which the same type of signals are applied may be arranged adjacent to each other. For example, the first signal pads CPe may be arranged consecutively, and the second signal pads CPg may be arranged consecutively. Accordingly, the potential difference between adjacent connection pads CP may be reduced or minimized, and the electrical stability and reliability of the connection pads CP may be improved.

The first signal pads CPe may be the connection pads CP for transmitting the electrode selection signals Se to the selector TMX of the display panel 100. For example, the first signal pads CPe may be electrically connected to the touch driver 400, and the electrode selection signals Se outputted from the touch driver 400 may be transmitted to the gate electrodes of the first switches SW1 through the first signal pads CPe and the control pads CTP connected to the first signal pads CPe.

In some example embodiments, each of the sub-groups SGR of the display panel 100 may include up to 12 sensor electrodes TSE. In this case, the connection pads CP of the circuit board 300 may include 12 first signal pads CPe1 to CPe12 configured to transmit 12 electrode selection signals Se, for sequentially selecting 12 or fewer sensor electrodes TSE included in each sub-group SGR, to the respective control pads CTP. For example, the connection pads CP may include the first signal pad CPe1 to which the first electrode selection signal Se1 is applied, which is transmitted to the first switch SW11 connected to the first sensor electrode TSE of each sub-group SGR, the first signal pad CPe2 to which the second electrode selection signal Se2 is applied, which is transmitted to the first switch SW12 connected to the second sensor electrode TSE of each sub-group SGR, the first signal pad CPe3 to which the third electrode selection signal Se3 is applied, which is transmitted to the first switch SW13 connected to the third sensor electrode TSE of each sub-group SGR, and the first signal pad CPe4 to which the fourth electrode selection signal Se4 is applied, which is transmitted to the first switch SW14 connected to the fourth sensor electrode TSE of each sub-group SGR. In this manner, the connection pads CP may include the fifth to twelfth signal pads CPe5 to CPe12 to which the fifth to twelfth electrode selection signals Se are applied, which are transmitted to the fifth to twelfth first switches SW1 of each sub-group SGR, respectively.

The second signal pads CPg may be the connection pads CP for transmitting the group selection signals Sg to the selector TMX of the display panel 100. For example, the second signal pads CPg may be electrically connected to the touch driver 400, and the group selection signals Sg outputted from the touch driver 400 may be transmitted to the gate electrodes of the second switches SW2 through the second signal pads CPg and the control pads CTP connected to the second signal pads CPg.

In some example embodiments, the sensor electrodes TSE of the display panel 100 may be divided into the plurality of groups GR, each of which includes the eight sub-groups SGR1 to SGR8. In this case, the connection pads CP of the circuit board 300 may include eight second signal pads CPg1 to CPg8 configured to transmit the eight group selection signals Sg1 to Sg8, for selecting the eight sub-groups SGR1 to SGR8 included in each group GR, to the respective control pads CTP. For example, the connection pads CP may include the second signal pad CPg1 to which the first group selection signal Sg1 is applied, and the second signal pad CPg2 to which the second group selection signal Sg2 is applied. In this manner, the connection pads CP may include the second signal pads CPg3 to CPg8 to which the third to eighth group selection signals Sg3 to Sg8 are applied, respectively.

In some example embodiments, the second signal pads CPg may be arranged in an order corresponding to the order in which the second switches SW2 of the selector TMX are arranged. For example, the second signal pads CPg1, CPg3, CPg5 and CPg7, which apply the first, third, fifth and seventh group selection signals Sg1, Sg3, Sg5, and Sg7 to the second switches SW21, SW23, SW25, and SW27 that are electrically connected to the sensor electrodes TSE of the odd column through the first, third, fifth and seventh multiplexers MUX1, MUX3, MUX5, and MUX7, may be arranged consecutively or sequentially. In addition, the second signal pads CPg2, CPg4, CPg6, and CPg8, which apply the second, fourth, sixth and eighth group selection signals Sg2, Sg4, Sg6, and Sg8 to the second switches SW22, SW24, SW26, and SW28 that are electrically connected to the sensor electrodes TSE of the even column through the second, fourth, sixth and eighth multiplexers MUX2, MUX4, MUX6, and MUX8, may be arranged consecutively or sequentially next to the second signal pads CPg1, CPg3, CPg5, and CPg7.

In some example embodiments, the number of first switches SW1 connected to some (e.g., one or more) of the second switches SW2 may be different from the number of first switches SW1 connected to other second switches SW2. For example, each of the second switches SW21 to SW26, which are electrically connected to the first to sixth multiplexers MUX1 to MUX6, may be electrically connected to J (e.g., twelve) first switches SW11 to SW1j and each of the second switches SW27 and SW28, which are electrically connected to the seventh and eighth multiplexers MUX7 and MUX8, may be electrically connected to fewer than J (e.g., four) first switches SW11 to SW14.

In addition, the number of times at least one second switch SW2 is turned on may be different from the number of times the other second switches SW2 are turned on. Accordingly, the effective voltage of the group selection signal Sg inputted to at least one second signal pad CPg may be different from the effective voltage of the group selection signal Sg inputted to other second signal pads CPg. For the purposes of discussion herein, the effective voltage may refer to the Root Mean Square (RMS) voltage.

For example, the second switches SW21 to SW26 electrically connected to the first to sixth multiplexers MUX1 to MUX6, respectively, may be turned on in synchronization with the period during which the 12 sensor electrodes TSE included in each of the first to sixth sub-groups SGR1 to SGR6 are selected. Each of the first to sixth group selection signals Sg1 to Sg6 may have a gate-on voltage Von 12 times during one cycle 1P (e.g., one driving cycle or one sensing period during which the sensor electrodes TSE included in each of the first to sixth sub-groups SGR1 to SGR6 are selected), as illustrated in FIG. 15, and may have a gate-off voltage Voff during a period in which the sensor electrodes TSE included in each of the first to sixth sub-groups SGR1 to SGR6 are not selected. For example, the number of gate-on pulses of each of the first to sixth group selection signals Sg1 to Sg6 included in the one cycle 1P may be twelve. The first to sixth group selection signals Sg1 to Sg6 may have substantially the same waveform, but the application timing of the gate-on voltage Von by the first to sixth group selection signals Sg1 to Sg6 may be different. In addition, the effective voltages of the first to sixth group selection signals Sg1 to Sg6 may be substantially equal to each other.

On the other hand, the second switches SW27 and SW28 connected to the seventh and eighth multiplexers MUX7 and MUX8, respectively, may be turned on in synchronization with the period during which the four sensor electrodes TSE included in each of the seventh and eighth sub-groups SGR7 and SGR8 are selected. Each of the seventh and eighth group selection signals Sg7 and Sg8 may have a gate-on voltage Von four times during one cycle 1P (e.g., one driving cycle or one sensing cycle in which the sensor electrodes TSE included in each of the seventh and eighth sub-groups SGR7 and SGR8 are selected), as illustrated in FIG. 16, and may have the gate-off voltage Voff during a period in which the sensor electrodes TSE included in each of the seventh and eighth sub-groups SGR7 and SGR8 are not selected. For example, the number of gate-on pulses of each of the seventh and eighth group selection signals Sg7 and Sg8 included in the one cycle 1P may be four. The seventh and eighth group selection signals Sg7 and Sg8 may have substantially the same waveform, but the application timing of the gate-on voltage Von by the seventh and eighth group selection signals Sg7 and Sg8 may be different. In addition, the effective voltages of the seventh and eighth group selection signals Sg7 and Sg8 may be substantially equal to each other.

In some example embodiments, the second switches SW2 may be formed as P-type transistors. The gate-on voltage Von of each of the first to eighth group selection signals Sg1 to Sg8 may be a low-level voltage configured to turn on the P-type transistors, and the gate-off voltage Voff of each of the first to eighth group selection signals Sg1 to Sg8 may be a high-level voltage configured to turn off the P-type transistors.

Accordingly, the effective voltages of the first to sixth group selection signals Sg1 to Sg6 may be different from the effective voltages of the seventh and eighth group selection signals Sg7 and Sg8. For example, the effective voltage of each of the seventh and eighth group selection signals Sg7 and Sg8 may be higher than the effective voltage of each of the first to sixth group selection signals Sg1 to Sg6. For example, the effective voltage of each of the seventh and eighth group selection signals Sg7 and Sg8 may be 9.35 V (or about 9.35 V), and the effective voltage of each of the first to sixth group selection signals Sg1 to Sg6 may be 8.15 V (or about 8.15 V). In this case, the difference in effective voltage between the group selection signals Sg may be 1 V (or about 1 V) or higher.

Among the connection pads CP (e.g., the second signal pads CPg) electrically connected to the gate electrodes of the respective second switches SW2 through the respective control pads CTP, the connection pads CP, to which different effective voltages are applied, may be referred to as "first connection pad CP1" and "second connection pad CP2." For example, in the second signal pads CPg electrically connected to the gate electrodes of the second switches SW2, among the second signal pads CPg to which a relatively low effective voltage is applied, each of the second signal pads CPg1 to CPg6, which are connected to the second switches SW21 to SW26 connected to the first to sixth multiplexers MUX1 to MUX6 through a first group of control pads CTP (e.g., the touch electrode pads TP) to which the first to sixth group selection signals Sg1 to Sg6 are applied, may also be referred to as "first connection pad CP1." In addition, in the second signal pads CPg electrically connected to the gate electrodes of the second switches SW2, among the second signal pads CPg to which a relatively high effective voltage is applied, each of the second signal pads CPg7 and CPg8, which are connected to the second switches SW27 and SW28 connected to the seventh and eighth multiplexers MUX7 and MUX8 through a second group of control pads CTP (e.g., the touch electrode pads TP) to which the seventh and eighth group selection signals Sg7 and Sg8 are applied, may also be referred to as "second connection pad CP2." Among the connection pads CP of the circuit board 300, each of the connection pads CP (e.g., the first signal pads CPe), which are connected to the respective first switches SW1 through a third group of control pads CTP to which the electrode selection signals Se are applied, may also be referred to as "third connection pad CP3."

In addition, the group selection signal Sg (e.g., one of the first to sixth group selection signals Sg1 to Sg6) applied to the first connection pad CP1 may also be referred to as "first selection signal," and the group selection signal Sg (e.g., one of the seventh and eighth group selection signals Sg7 and Sg8) applied to the second connection pad CP2 may also be referred to as "second selection signal." In addition, the effective voltage applied to the first connection pad CP1 may also be referred to as "first effective voltage," and the effective voltage applied to the second connection pad CP2 may also be referred to as "second effective voltage."

In some example embodiments, the effective voltage of each of the seventh and eighth group selection signals Sg7 and Sg8 may be higher than the effective voltage of each of the electrode selection signals Se applied to the first signal pads CPe. For example, the effective voltage of each of the electrode selection signals Se applied to the first signal pads CPe1 to CPe4 connected to the first to fourth first switches SW1 of each of the first to eighth multiplexers MUX1 to MUX8 may be 8.75 V (or about 8.75 V ) and the effective voltage of each of the selection signals Se applied to the first signal pads CPe5 to CPe12 connected to the fifth to twelfth first switches SW1 of each of the first to sixth multiplexers MUX1 to MUX6 may be 9.05 V (or about 9.05 V), which may be lower than the effective voltage of each of the seventh and eighth group selection signals Sg7 and Sg8.

The effective voltage difference between the selection signals respectively applied to the connection pad CP may be a factor that reduces or deteriorates the reliability of the connection pads CP. For example, the second signal pads CPg7 and CPg8, to which the seventh and eighth group selection signals Sg7 and Sg8 having relatively high effective voltages are applied, may be susceptible to corrosion compared to the surrounding second signal pads CPg1 to CPg6 to which the first to sixth group selection signals Sg1 to Sg6 are applied.

For example, when the display device 1 is driven in a high temperature/high humidity environment, impurities may flow into the connection pads CP of the circuit board 300 from the lower part of the substrate 110 (see FIGS. 8 and 9). For example, when impurities such as fluorine (F) or sulfur (S) flow into the pad area FPA of the circuit board 300 from the adhesive layer 160 and/or the lower film 170 of FIGS. 8 and 9, relatively more impurities may flow into the second signal pads CPg7 and CPg8 to which a higher voltage is applied compared to other connection pads CP, thereby corroding the plating film MPL (see FIG. 9) of the second signal pads CPg7 and CPg8.

As a result, a contact failure may occur, or the quality of contact may be deteriorated between the control pads CTP of the display panel 100 and the second signal pads CPg of the circuit board 300. Hereinafter, example embodiments for providing a relatively more stable connection of the display panel 100 to the circuit board 300 by limiting, preventing or suppressing corrosion of the second signal pads CPg are disclosed.

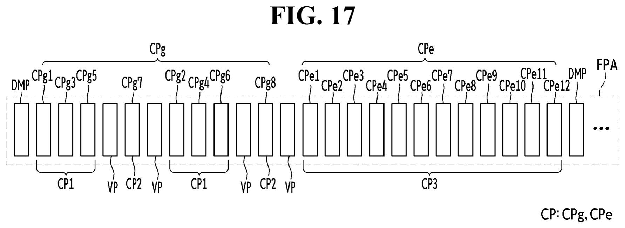

FIG. 17 shows a pad area of a circuit board according to some example embodiments. Compared to FIG. 14, FIG. 17 shows some example embodiments in which voltage pads VP are further arranged around the connection pads CP.

Referring to FIG. 17 in addition to FIGS. 14 to 16, the circuit board 300 may further include at least one voltage pad VP arranged around the second signal pads CPg. For example, the circuit board 300 may include the voltage pads VP arranged on at least one side of each of the second signal pads CPg7 and CPg8 to which the seventh and eighth group selection signals Sg7 and Sg8 are respectively applied. For example, the circuit board 300 may include four voltage pads VP arranged on either side of each of the second signal pads CPg7 and CPg8 to which the seventh and eighth group selection signals Sg7 and Sg8 are respectively applied.

The voltage pads VP may be arranged between each of the second signal pads CPg7 and CPg8, to which the seventh and eighth group selection signals Sg7 and Sg8 are applied, and other surrounding connection pads CP. For example, the voltage pads VP may be arranged between the adjacent first connection pad CP1 and second connection pad CP2, and between the adjacent second connection pad CP2 and third connection pad CP3.

The pads arranged in the pad area FPA of the circuit board 300 may have substantially the same or similar shape and/or structure. For example, each of the connection pads CP, the voltage pads VP, and the dummy pads DMP may be formed as a bump-type pad protruding toward the pad portion PA of the display panel 100 and may include the metal core MC (see FIG. 9) (e.g., a copper core containing copper (Cu)) and the plating film MPL (see FIG. 9) (e.g., a nickel plating film containing nickel (Ni)).

A high-level voltage having an effective voltage greater than the effective voltages of the selection signals applied to the first and second signal pads CPe and CPg may be applied to the voltage pads VP. In some example embodiments, the voltage pads VP may be continuously applied with a constant voltage that is maintained at a relatively higher level voltage. For example, the voltage pads VP may be electrically connected to the touch driver 400, and a gate-high voltage outputted from the touch driver 400 may be applied to the voltage pads VP. For example, a high-level constant voltage of 10 V may be applied to each voltage pad VP. The gate-high voltage applied to the voltage pads VP may correspond to the gate-off voltage Voff of the electrode selection signals Se and/or the group selection signals Sg, but is not limited thereto.

The voltage pads VP may be connected to or floated on the electrode pads (e.g., the touch electrode pads TP) of the display panel 100. In addition, the high-level constant voltage applied to the voltage pads VP may be applied to a given or desired circuit element (e.g., an ESD diode connected to at least one second connection line TCL (see FIG. 6 or FIG. 7) that transmits a selection signal to the selector TMX), wiring or the like of the display panel 100 to be used for driving and/or stabilizing the display panel 100, or may be a voltage that is not used in the display panel 100.

According to the example embodiments discussed above, corrosion of the connection pads CP may be reduced, prevented, or suppressed by arranging the voltage pads VP around the connection pads CP (e.g., the second connection pads CP2) to which a relatively higher voltage is applied. For example, by allowing impurities to flow into the voltage pads VP instead of the connection pads CP, the voltage pads VP may be corroded, and corrosion of the connection pads CP may be reduced, prevented, or suppressed. Accordingly, the quality of contact between the display panel 100 and the circuit board 300 may be improved, and the reliability of the display device 1 may be improved.

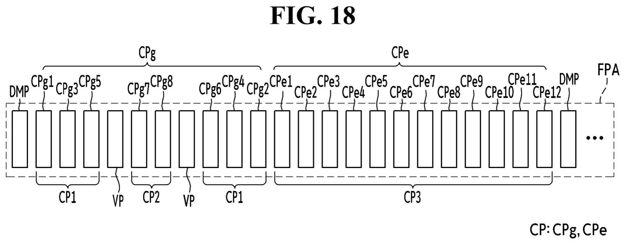

FIG. 18 shows a pad area of a circuit board according to some example embodiments. Compared to FIG. 17, FIG. 18 shows some example embodiments in which the arrangement structure of the second signal pads CPg and the voltage pads VP is different.

Referring to FIG. 18 in addition to FIGS. 14 to 17, the number of voltage pads VP may be reduced or minimized by consecutively arranging a plurality of second connection pads CP2. For example, a pair of second signal pads CPg7 and CPg8 to which the seventh and eighth group selection signals Sg7 and Sg8 are applied may be arranged consecutively, and the voltage pads VP may be arranged on parallel opposite sides of the pair of second signal pads CPg7 and CPg8. Accordingly, the number of voltage pads VP may be reduced by half.

In some example embodiments, the arrangement order of the second signal pads CPg2, CPg4, CPg6 and CPg8, to which the second, fourth, sixth, and eighth group selection signals Sg2, Sg4, Sg6 and Sg8 are applied, may also be changed. For example, compared to the example embodiments of FIG. 14 or FIG. 17, in the example embodiment of FIG. 18, the second signal pads CPg2, CPg4, CPg6 and CPg8, to which the second, fourth, sixth, and eighth group selection signals Sg2, Sg4, Sg6 and Sg8 are applied, may be arranged in the reverse order.

As in the example embodiment of FIG. 17, in the example embodiment of FIG. 18, the voltage pads VP are also arranged around the second connection pads CP2 to which a relatively high voltage is applied, thereby reducing, preventing, or suppressing corrosion of the second connection pads CP2. In addition, according to example embodiments of FIG. 18, the number of voltage pads VP may be reduced or minimized by more efficiently arranging the second signal pads CPg and the voltage pads VP.

According to some example embodiments of FIGS. 17 and 18, the voltage pads VP, to which an effective voltage higher than the effective voltages of the input signals applied to the connection pads CP are applied, may be arranged around the connection pads CP of the circuit board 300 that are configured to transmit input signals having a relatively higher effective voltage, among the input signals (e.g., the selection signals inputted to the first switch unit SWU1 and the second switch unit SWU2) inputted to the selector TMX of the touch sensing unit 11_2, to the display panel 100. For example, among the electrode selection signals Se and the group selection signals Sg applied to the gate electrodes of the first switches SW1 and the second switches SW2, which are connected between each channel pad CHP and the sensor electrodes TSE included in each group GR of the touch sensing unit 11_2, the effective voltages of the seventh and eighth group selection signals Sg7 and Sg8, which are used to select a relatively small number of sensor electrodes TSE, may be higher than the effective voltages of the other selection signals. The voltage pads VP, to which a high-level voltage (e.g., a high-level constant voltage) higher than the effective voltages of the seventh and eighth group selection signals Sg7 and Sg8 is applied, may be arranged on one or parallel opposite sides of each of the second signal pads CPg7 and CPg8 to which the seventh and eighth group selection signals Sg7 and Sg8 are respectively applied. According to some example embodiments, corrosion of the connection pads CP including second signal pads CPg7 and CPg8, to which the seventh and eighth group selection signals Sg7 and Sg8 are applied, may be reduced, prevented, or suppressed. Accordingly, the reliability of the display module 11 including the circuit board 300 according to some example embodiments and the display device 1 including the same, may be improved.

In the aforementioned example embodiments, the pad arrangement structure of the circuit board 300 for reducing, limiting, or preventing corrosion of the connection pads CP transmitting the input signals to the selector TMX of the touch sensing unit 11_2 has been described, but the scope of example embodiments is not limited thereto. For example, corrosion of the connection pad CP may be reduced, prevented or suppressed by arranging at least one voltage pad VP to which a higher voltage is applied around the connection pad CP, which is relatively more susceptible to corrosion than other surrounding connection pads CP, among the connection pads CP of the circuit board 300 for transmitting the respective input signals and/or input voltages to the display panel 100.

For example, the display device 1 according to some example embodiments may include the display panel 100 and the circuit board 300 including the connection pads CP joined onto the pad portion PA of the display panel 100. In addition, the circuit board 300 according to some example embodiments may include the voltage pad VP arranged around the connection pad CP that is more susceptible to corrosion than other surrounding connection pads CP, and a voltage may be applied to the voltage pad VP such that the voltage pad VP is more susceptible to corrosion than the connection pads CP. For example, among the connection pads CP to which a positive voltage is applied, a given connection pad CP to which a signal or voltage having a relatively high effective voltage is applied may be more susceptible to corrosion. For example, the voltage pad VP is located on at least one side of a given connection pad CP, and a high-level voltage having an effective voltage higher than the effective voltage of a signal or voltage applied to the given connection pad CP may be applied to the voltage pad VP. In some example embodiments, a constant voltage maintained at a constant high level may be applied to the voltage pad VP. Accordingly, the safety of the connection pads CP may be improved.

According to the type of impurities flowing into the pad area FPA of the circuit board 300, among the connection pads CP to which a negative voltage is applied, a connection pad CP, to which a signal or voltage having a relatively low effective voltage is applied, may be relatively more susceptible to corrosion. For example, when potassium ions (K⁺) and the like are introduced, the impurities may be concentrated on a given connection pad CP to which a signal or voltage having a relatively low effective voltage is applied, among the connection pads CP to which a negative voltage is applied. For example, by locating the voltage pad VP on at least one side of the given connection pad CP and applying a low-level voltage (e.g., a gate-low voltage outputted from the touch driver 400) having an effective voltage lower than the effective voltage of a signal or voltage applied to the given connection pad CP to the voltage pad VP, corrosion of the given connection pad CP may be reduced, limited, or prevented.

According to some example embodiments, corrosion of the connection pads CP of the circuit board 300 may be reduced, prevented, or suppressed. Accordingly, the quality of contact between the display panel 100 and the circuit board 300 may be improved, and the reliability of the display module 11 and the display device 1 including the same may be improved.

The display device 1 according to some example embodiments discussed above may be used in various electronic devices. The electronic device according to some example embodiments may include the above-described display device 1 (or the display module 11 according to at least some example embodiments), and may further include modules or devices having functions in addition to the display device 1.

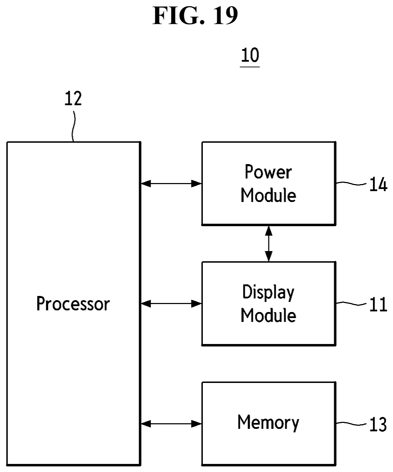

FIG. 19 is a block diagram of an electronic device according to some example embodiments.

Referring to FIG. 19, an electronic device 10 according to some example embodiments may include a display module 11, a processor 12, a memory 13, and a power module 14.

The electronic device 10 may output information in the form of images through the display module 11. For example, when the processor 12 executes an application stored in the memory 13, image information provided by the application may be provided to a user through the display module 11.

The display module 11 may include a display panel for displaying an image and a circuit board connected to the display panel. The display module 11 may be the display module 11 according one or more example embodiments described with reference to FIGS. 2 to 18. For example, the display module 11 may include the display panel 100 and the circuit board 300 according to some example embodiments discussed above.

The processor 12 may include at least one of a central processing unit (CPU), an application processor (AP), a graphic processing unit (GPU), a communication processor (CP), an image signal processor (ISP), or a controller.

The memory 13 may store data information used for the operation of the processor 12 or the display module 11. For example, the memory 13 may store an image data signal and/or an input control signal.

The processor 12 may control the display module 11 using information stored in the memory 13. The processor 12 may transmit the image data signal and/or the input control signal stored in the memory 13 to the display module 11. For example, when the processor 12 executes an application stored in the memory 13, an image data signal and/or an input control signal is transmitted to the display module 11 (e.g., the circuit board 300 of the display module 11), and the display module 11 may process the received signal and output image information through a display screen.

The power module 14 may include a power supply module, such as a power adapter or a battery device, and a power conversion module that converts power supplied by the power supply module to generate power required for the operation of the electronic device 10. For example, the power module 14 may convert power supplied by the power supply module to generate power required for the operation of the display module 11, and may supply the generated power to the display module 11 (e.g., the circuit board 300 of the display module 11).

At least one of the components of the electronic device 10 described above may be included in the display device 1 according to some example embodiments described above. Further, some of individual modules functionally included in one module may be included in the display device 1 and some others may be provided separately from the display device 1. For example, the display device 1 may include the display module 11, and the processor 12, the memory 13, and the power module 14 may be provided in the form of other devices in the electronic device 10 other than the display device 1.

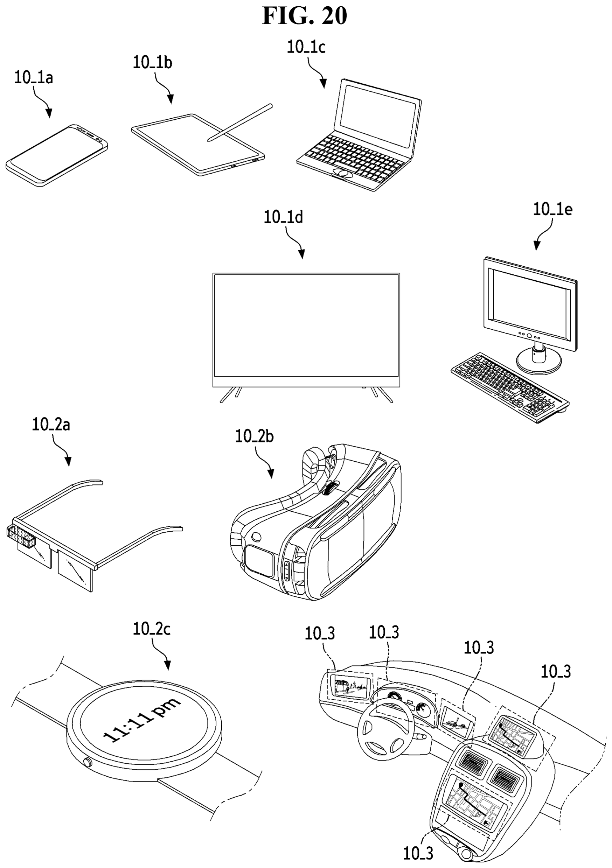

FIG. 20 illustrates schematic views of electronic devices according to some example embodiments.

Referring to FIG. 20, electronic devices that may include the display device 1 according to some example embodiments may include an image display electronic device such as a smartphone 10_1a, a tablet PC 10_1b, a laptop 10_1c, a TV 10_1d, and a desk monitor 10_1e, a wearable electronic device including a display module, such as smart glasses 10_2a, a head mounted display 10_2b, or a smart watch 10_2c, a vehicle electronic device 10_3 including a display module, such as a center fascia, and a dashboard of an automobile, a center information display (CID) placed on the dashboard, a room mirror display, and the like.

As described herein, any devices, systems, modules, portions, units, controllers, circuits, and/or portions thereof according to any of the example embodiments, and/or any portions thereof (including, without limitation, the display module 11, the processor 12, the memory 13, the power module 14, the smartphone 10_1a, the tablet PC 10_1b, the laptop 10_1c, the TV 10_1d, the desk monitor 10_1e, the smart glasses 10_2a, the head mounted display 10_2b, the smart watch 10_2c, the vehicle electronic device 10_3, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), a System-on-Chip (SoC), a programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments. The processing circuitry may include electrical components such as at least one of transistors, resistors, capacitors, etc. The processing circuitry may include electrical components such as logic gates including at least one of AND gates, OR gates, NAND gates, NOT gates, etc.

While several embodiments have been provided in the present disclosure, it should be understood that the disclosed systems and methods might be embodied in many other specific forms without departing from the scope of the present disclosure as defined by the appended claims. The present examples are to be considered as illustrative and not restrictive, and the intention is not to be limited to the details given herein. For example, the various elements or components may be combined or integrated in another system or certain features may be omitted, or not implemented.

## Claims

1. A display device (1) comprising a display module (11), the display module (11) comprising:
a display panel (100) comprising pixels (PX) on a substrate (110), sensor electrodes (TSE) on an encapsulation layer (140) covering the pixels (PX), a display driver (200) on the substrate (110) and electrically connected to the pixels (PX), a selector (TMX) comprising a plurality of switches (SW) electrically connected to the sensor electrodes (TSE) and on the substrate (110), and electrode pads (DP, TP) on the substrate (110), the electrode pads (DP, TP) including a plurality of display electrode pads (DP) electrically connected to the display driver (200) and a plurality of touch electrode pads (TP) electrically connected to the plurality of switches (SW); and
a circuit board (300) comprising connection pads (CP) connected to the electrode pads (DP, TP),
wherein the connection pads (CP) comprise a first connection pad (CP1) and a second connection pad (CP2), and the first connection pad (CP1) and the second connection pad (CP2) are electrically connected to different switches (SW) of the plurality of switches (SW) via different touch electrode pads (TP) of the plurality of touch electrode pads (TP), the first connection pad (CP1) and the second connection pad (CP2) being configured to receive selection signals (Sg) having different effective voltages, and
wherein the circuit board (300) further comprises a voltage pad (VP) between the first connection pad (CP1) and the second connection pad (CP2), the voltage pad (VP) being configured to receive a constant voltage having an effective voltage greater than the effective voltages of the selection signals (Sg).

2. The display device (1) of claim 1, wherein the effective voltage of the selection signal (Sg) received by the second connection pad (CP2) is higher than the effective voltage of the selection signal (Sg) received by the first connection pad (CP1), and
the circuit board (300) comprises a plurality of voltage pads (VP), each voltage pad (VP) of the plurality of voltage pads (VP) being configured to receive the constant voltage and being on opposite sides of the second connection pad (CP2).

3. The display device (1) of claim 1 or 2, wherein the connection pads (CP) comprise:
a plurality of first connection pads (CP1), each first connection pad (CP1) of the plurality of first connection pads (CP1) being configured to receive a respective selection signal (Sg), the selection signals (Sg) having a same first effective voltage; and
a plurality of second connection pads (CP2), each second connection pad (CP2) of the plurality of second connection pads (CP2) being configured to receive a respective selection signal (Sg), the selection signals (Sg) having a same second effective voltage.

4. The display device (1) of claim 3, wherein the circuit board (300) comprises a plurality of voltage pads (VP), each voltage pad (VP) of the plurality of voltage pads (VP) being configured to receive the constant voltage and being on opposite sides of each second connection pad (CP2) of the plurality of second connection pads (CP2).

5. The display device (1) of claim 3 or 4, wherein the plurality of second connection pads (CP2) are sequential in an order corresponding to an arrangement of the plurality of switches (SW) of the selector (TMX).

6. The display device (1) of claim 5, wherein the circuit board (300) comprises a plurality of voltage pads (VP), each voltage pad (VP) of the plurality of voltage pads (VP) being configured to receive the constant voltage and being on a first side of the plurality of second connection pads (CP2) and a second side of the plurality of second connection pads (CP2).

7. The display device (1) of any one of the preceding claims, wherein each of the connection pads (CP) and the voltage pad (VP) comprises:
a metal core (MC) protruding from one surface of the circuit board (300) toward the display panel (100); and
a plating film (MPL) covering a surface of the metal core.

8. The display device (1) of claim 7, wherein the metal core (MC) includes copper, and
the plating film (MPL) includes nickel.

9. The display device (1) of any one of the preceding claims, wherein the plurality of touch electrode pads (TP) comprise a channel pad (CHP) selectively connected to one group of sensor electrodes (TSE) of the sensor electrodes (TSE) by the selector (TMX).

10. The display device (1) of claim 9, wherein the selector (TMX) comprises:
a first switch unit (SWU1) comprising a plurality of first switches (SW1) individually connected to the sensor electrodes (TSE) of the one group and configured to turn on in response to respective electrode selection signals (Sg) being received by respective gate electrodes (GE); and
a second switch unit (SWU2) comprising a plurality of second switches (SW2) electrically connected to different first switches (SW1) of the plurality of first switches (SW1) and electrically connected between the first switch unit (SWU1) and the channel pad (CHP).

11. The display device (1) of claim 10, wherein the first connection pad (CP1) is connected to a gate electrode (GE) of at least one second switch (SW2) of the plurality of second switches (SW2), the at least one second switch (SW2) being electrically connected to a first number of first switches (SW1),
the second connection pad (CP2) is connected to a gate electrode (GE) of at least one other second switch (SW2) of the plurality of second switches (SW2), the at least one other second switch (SW2) being electrically connected to a second number of first switches (SW1), and
the first number of first switches (SW1) is greater than the second number of first switches (SW1).

12. The display device (1) of claim 10 or 11, wherein the first connection pad (CP1) is configured to receive a first number of gate-on pulses of a first selection signal (Sg) and the second connection pad (CP1) is configured to receive a second number of gate-on pulses of a second selection signal (Sg), the first number of gate-on pulses being greater than the second number of gate-on pulses.

13. The display device (1) of any one of claims 10 to 12,
wherein each second switch (SW2) of the plurality of second switches (SW2) includes a P-type transistor, and
an effective voltage of the second selection signal (Sg) is higher than an effective voltage of the first selection signal (Sg).

14. The display device (1) of any one of claims 10 to 13, wherein the circuit board (300) comprises a plurality of voltage pads (VP), and the plurality of voltage pads (VP) are on opposite sides of the second connection pad (CP2).

15. An electronic device (10) comprising:
a display device (1) of any one of the preceding claims;
a processor (12) configured to transmit an image data signal to the display module (11); and
a power module (14) configured to supply power to the display module (11).
